(19) Europäisches Patentamt
European Patent Office
Office européen des brevets

(11) **EP 3 224 639 B1**

(12) **EUROPÄISCHE PATENTSCHRIFT**

(45) Veröffentlichungstag und Bekanntmachung des Hinweises auf die Patenterteilung:
**24.10.2018 Patentblatt 2018/43**

(21) Anmeldenummer: **15800817.7**

(22) Anmeldetag: **24.11.2015**

(51) Int Cl.:
*G01R 33/00* (2006.01)        *G01R 33/09* (2006.01)
*G01R 33/04* (2006.01)

(86) Internationale Anmeldenummer:
**PCT/EP2015/077571**

(87) Internationale Veröffentlichungsnummer:
**WO 2016/083420 (02.06.2016 Gazette 2016/22)**

(54) **MAGNETORESISTIVE WHEATSTONE-MESSBRÜCKE UND WINKELSENSOR MIT ZUMINDEST ZWEI DERARTIGEN MESSBRÜCKEN**

MAGNETORESISTIVE WHEATSTONE MEASURING BRIDGE AND ANGLE SENSOR HAVING AT LEAST TWO SUCH MEASURING BRIDGES

PONT DE MESURE DE WHEATSTONE MAGNÉTORÉSISTIF ET CAPTEUR D'ANGLE MUNI D'AU MOINS UN TEL PONT DE MESURE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.11.2014 DE 102014117160**

(43) Veröffentlichungstag der Anmeldung:
**04.10.2017 Patentblatt 2017/40**

(73) Patentinhaber: **Sensitec GmbH**
**35633 Lahnau (DE)**

(72) Erfinder:
• **PAUL, Johannes**
**55128 Mainz (DE)**

• **ALAVI, Golzar**
**70563 Stuttgart (DE)**
• **YIN, Tsung-I**
**60322 Frankfurt (DE)**

(74) Vertreter: **Spachmann, Holger**
**Stumpf Patentanwälte PartGmbB**
**Alte Weinsteige 73**
**70597 Stuttgart (DE)**

(56) Entgegenhaltungen:
**DE-A1- 19 839 450        DE-C1- 4 438 715**
**US-A1- 2002 006 017    US-A1- 2008 272 771**
**US-A1- 2013 099 783**

EP 3 224 639 B1

**Beschreibung**

Die Erfindung betrifft eine magnetoresistive Wheatstone-Messbrücke sowie einen magnetoresistiven Winkelsensor zur Messung der Winkelausrichtung eines Magnetfeldes, der zumindest eine Wheatstone-Messbrücke, bevorzugt zwei oder mehrere um einen vordefinierten Winkel versetzte Wheatstone-Messbrücken nach der Lehre des Anspruchs 1 aufweist.

Hierzu umfassen die beiden parallel geschalteten Brückenzweige der Wheatstone-Messbrücke, die auch als Halbbrücken bezeichnet werden, jeweils zwei in Reihe geschaltete magnetoresistive Widerstandsanordnungen R1 und R3 bzw. R2 und R4. Die Widerstandsanordnungen R1, R4 und R2, R3 der beiden Brückenzweige liegen sich jeweils diagonal gegenüber und die Widerstandsanordnungen R1, R2 bzw. R3, R4 der beiden Brückenzweige liegen sich paarweise gegenüber. Jede Widerstandsanordnung weist eine magnetisch sensitive Vorzugsrichtung, die auch als Empfindlichkeitsrichtung bezeichnet werden kann, auf, in der ein Magnetfeld mit einer maximal möglichen Empfindlichkeit messbar ist.

Die Erfindung ermöglicht eine verbesserte Genauigkeit einer Winkelerfassung durch einen magnetischen Winkelsensor.

TECHNISCHER HINTERGRUND

Als magnetoresistive Effekte bezeichnet man alle Effekte, die die Änderung des elektrischen Widerstands eines Materials durch Anlegen eines äußeren Magnetfeldes beschreiben. Magnetoresistive Effekte, die eine Vorzugsrichtung in Bezug auf die vektorielle Richtung eines zu messenden Magnetfeldes aufweisen sind insbesondere der anisotrope magnetoresistive Effekt (AMR-Effekt), der Riesenmagnetowiderstand (GMR-Effekt), der CMR-Effekt, und der TMR-Effekt.

Im Stand der Technik sind magnetoresistive Winkelsensoren häufig in Form einer Wheatstone Brücke ausgelegt, wobei in jedem Brückenzweig gleiche magnetoresistive Widerstandsmaterialien verwendet werden, die sich nur in ihrer Form bzw. magnetischen Ausrichtung voneinander unterscheiden. Durch diese Anordnung wird eine Temperaturunabhängigkeit des Ausgangssignals erreicht, da die temperaturabhängige Widerstandsveränderung in jedem Brückenzweig identisch ist, und somit eine temperaturbedingte Veränderung sich nicht auf ein Sensorsignal auswirkt.

Um eine Winkelinformation eindeutig zu erhalten, sind typischerweise zwei Wheatstone-Messbrücken erforderlich, die zueinander in verschiedener Ausrichtung ihre magnetische Empfindlichkeitsrichtung haben. Beispielsweise sind die beiden Brücken um 90° gedreht und man erhält eine Sinusfunktion und eine Kosinusfunktion im Brückenausgang im Falle eines sich drehenden zu detektierenden Magnetfeldes um den Drehwinkel $\vartheta$. Diese beiden Signale werden verwendet um eine eindeutige Winkelposition $\vartheta$ zu errechnen, zum Beispiel mittels der ARCTAN-Funktion. In Fällen anderer Winkelversetzungen beider Brücken kann mit geeigneten trigonometrischen Funktionen ebenfalls eine eindeutige Winkelausrichtung eines zu detektierenden Magnetfeldes berechnet werden.

AMR Widerstände (Anisotroper MagnetoResistiver Effekt) haben eine Widerstandsabhängigkeit, die mit dem Winkel zwischen Stromrichtung und Magnetisierungsrichtung korreliert, da die Periodizität bei AMR 180° beträgt.

Eine AMR Brücke zur Winkelmessung enthält daher magnetoresistive Streifen in verschiedenen Richtungen. Um ein phasenverschobenes Signal bei AMR zu erhalten, werden zwei Brücken verwendet, die beispielsweise um 45° zueinander gedreht sind.

GMR und TMR Widerstände (Giant MagnetoResistiver Effekt und TunnelMagnetoResistiver Effekt) haben eine Widerstandsabhängigkeit, die mit dem Winkel zwischen der Magnetisierungsrichtung des Freelayers und der Magnetisierungsrichtung des Pinnedlayers korreliert. Die Periodizität der Magnetfeldrichtungsabhängigkeit beträgt bei TMR- bzw. GMR-Widerständen 360°. Der Pinnedlayer weist eine magnetische Vormagnetisierung als Pinningrichtung auf, die eine Vorzugsrichtung definiert. Freelayer und Pinnedlayer sind magnetische Schichten, die durch eine nichtmagnetische Schicht getrennt, im Falle des TMR ist es ein dünner Isolator z.B. $Al_2O_3$ oder MgO, im Falle des GMR ist es eine dünne, leitfähige Schicht, z.B. Cu oder Ru. Der Freelayer ist so ausgebildet, dass seine Magnetisierungsrichtung dem äußeren Feld folgt, der Pinnedlayer ist so ausgebildet, dass seine Magnetisierungsrichtung bei angelegtem äußerem Feld möglichst stabil bleibt.

AMR-, TMR- oder GMR-basierte Widerstände in Wheatstone-Messbrücken, die eine definierbare Vorzugsrichtung zur Detektion eines sich drehenden Magnetfeldes aufweisen, können im Rahmen der Erfindung eingesetzt werden, da alle diese magnetoresistiven Widerstandsarten eine magnetoresistive Vorzugsrichtung aufweisen, in der eine Betragsänderung eines äußeren magnetischen Feldes eine maximal große Widerstandsänderung hervorruft, sprich, in der die höchste magnetoresistive Empfindlichkeit vorherrscht. Diese Vorzugsrichtung ist prozesstechnisch bei Herstellung des Sensorlayouts auf Chipebene oder durch eine elektrische bzw. magnetische Konfiguration in einer Wheatstone-Messbrücke definierbar.

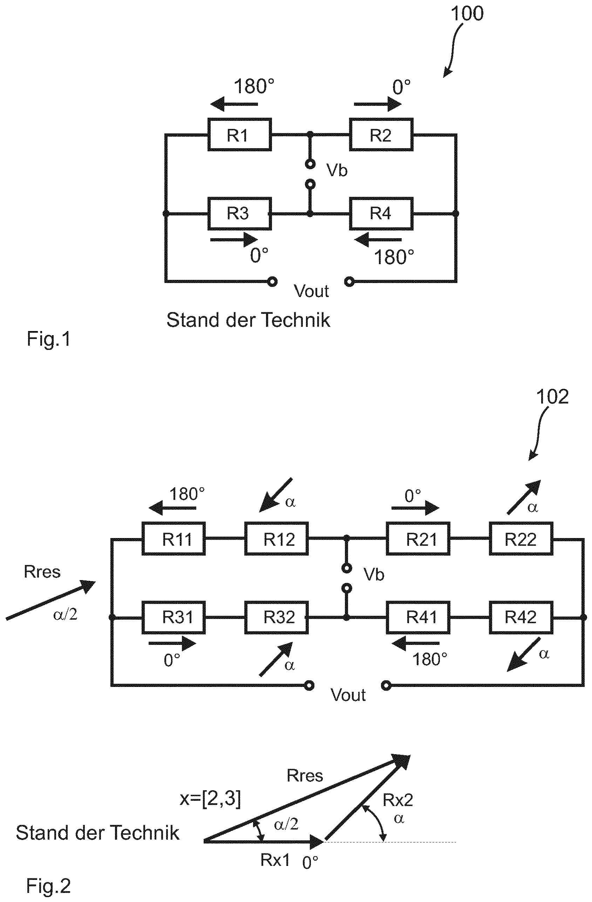

In Fig. 1 ist eine typische Wheatstone Brücke aus GMR- oder TMR- Sensoren dargestellt, die entgegengesetzte, d.h. antiparallele Vorzugsrichtungen in den einzelnen Brückenzweigen aufweist. Die vier magnetoresistiven Brückenwiderstände weisen einen identischen nominalen Widerstandsbetrag auf und bilden zwei Brückenzweige mit in Reihe geschalteten Brückenwiderstandsanordnungen R1 und R3 sowie parallel hierzu Brückenwiderstandsanordnungen R2 und R4, die zwischen der Versorgungspotentialdifferenz Vb liegen. In der Regel entspricht eine Brückenwiderstandsanordnungen einem einzelnen Brückenwiderstand, allerdings kann eine Brückenwiderstandsanordnungen auch zwei oder mehrere in Reihe oder parallele einzelne Brückenwiderstände umfassen. In den Mittenabgriffen zwischen den Brückenzweigen R1/R3 bzw. R2/R4 kann die Ausgangsspannung Vout abgegriffen werden. Die dargestellten Pfeile können z.B. die Pinningrichtung von GMR- oder TMR-Widerständen angeben und bezeichnen somit deren magnetoresistive Vorzugsrichtung. Alle Brückenwiderstände einer Brückenwiderstandsanordnung weisen eine identische magnetische Vorzugsrichtung auf. Im Fall von TMR- oder GMR-Widerständen ist der Widerstand minimal, wenn Freelayer und Pinninglayer in die gleiche Richtung magnetisiert sind und maximal bei antiparalleler Magnetisierung. Die Brückenwiderstandsanordnungen eines Brückenzweigs weisen antiparallele Vorzugsrichtungen und die diagonal liegenden Brückenwiderstandsanordnungen der beiden Brückenzweige identische Vorzugsrichtungen auf, d.h. R1 und R4 weisen dieselbe Vorzugsrichtung auf, und R2 und R3 weisen eine hiervon um 180° versetzte Vorzugsrichtung auf. Ein externes Magnetfeld, das in Vorzugsrichtung der Brückenwiderstandsanordnungen R2, R3 ausgerichtet ist, bewirkt eine Widerstandsminimierung in den Widerständen R2 und R3 sowie eine Widerstandsmaximierung in den Widerständen R1 und R4, so dass sich ein maximales oder minimales Ausgangssignal Vout ergibt.

Die Genauigkeit der Winkelmessung ist umso besser, je sinusförmiger die Ausgangssignale der eingesetzten Wheatstone Brücke zur Detektion des Magnetfeldwinkels sind, d.h. je mehr eine Messspannungsänderung des Brückenabgriffs sich bei einer angenommenen Drehung eines äußeren, zu detektierenden Magnetfeldes analog zur Winkeldrehung sinusförmig verhält. Es ist gewünscht, dass sich bei gleichen nominellen Widerstandsgrößen und Verhalten der Brückenwiderstände R1 bis R4 die Ausgangsspannung $Vout = A \cdot Vb \cdot cos(\vartheta)$ mit einem vom Widerstandsverhalten der Messbrücke abhängigen Skalierungsfaktor A ergibt, wobei sich $\vartheta$ als Winkel des äußeren Magnetfelds relativ zur der durch die Pfeile angezeige Vorzugsrichtung der magnetoresistiven Brückenwiderstände R2, R3 bzw. 180° versetzt zu den Widerständen R1, R4 richtet. Eine reine Sinus- bzw. Kosinusfunktion ist jedoch in der Praxis nur selten anzutreffen, Oberwellen verzerren den Sinus und somit kann die ARCTAN-Berechnung fehlerhaft sein, da diese einen reinen Sinus voraussetzt.

Oberwellen im Messspannungsverlauf können durch unterschiedliche Effekte bewirkt werden, z.B. dadurch, dass das rotierende Magnetfeld nicht gleichmäßig ist, z.B. durch Induktion, durch eine magnetische Anisotropie der verwendeten Widerstandsmaterialien, durch Toleranzen beim Zusammenbau von Sensor und Magnet oder Ungenauigkeiten oder Fehlausrichtungen von Polschuhen oder Magnetfeldleitelementen.

Bei GMR und TMR Sensoren ist ein wesentlicher Beitrag für Oberwellen die nicht exakt stabile Lage der Magnetisierung der Referenzschicht bzw. des Pinninglayers, der in der Praxis nur wenige Nanometer dick ist. In der Praxis neigt diese dazu, sich ein wenig mit dem äußeren Feld mitzudrehen. Der Drehwinkel ist dabei umso größer, je stärker das äußere Feld ist. Dadurch entstehen Oberwellen im Ausgangssignal. Es finden sich insbesondere die zweite, dritte, vierte und auch die fünfte Oberwelle in dem Ausgangssignal der Wheatstone Brücke, die zu Messungenauigkeiten führt.

Es herrscht daher ein Bedürfnis, Oberwellen bei der Winkelmessung mittels magnetoresistiver Widerstandsanordnungen zu verbessern.

## STAND DER TECHNIK

In der US 6 633 462 B2 ist ein Konzept zur Unterdrückung von Oberwellen beschrieben, bei der eine Brückenwiderstandsanordnung aus drei Teilwiderständen gebildet wird, einem zentralen und betragsmäßig größten Teilwiderstand, dessen Vorzugsrichtung in Richtung der zu messenden Komponente liegt, und zwei betragsmäßig kleineren Teilwiderständen, deren Vorzugsrichtung in einem gleichen positiven bzw. negativen Winkel von 5° bis 85° von der Vorzugsrichtung der zu messenden Komponente abweicht. Hierdurch kann eine Anisotropie von Materialien verringert und der sinusförmige Verlauf des Messsignals verbessert werden. Jede Brückenwiderstandsanordnung weist eine Vorzugsrichtung entsprechend der Vorzugsrichtung des zentralen Teilwiderstandes auf, diagonal angeordnete Brückenwiderstände weisen identische Vorzugsrichtungen auf.

Ein weiterer aus der der EP 2 455 720 A1 bekannter Stand der Technik ist es weiterhin, wie in Fig. 2 dargestellt, dass zwei Teilwiderstände RX1 und RX2 einer Brückenwiderstandsanordnung RX, d.h. R11 und R12 der Brückenwiderstandsanordnung R1 in Serie geschaltet werden, deren Pinningrichtungen und somit Vorzugsrichtungen um einen Winkel $\alpha$ versetzt sind. Dadurch wird die 180°/$\alpha$ -te Oberwelle gefiltert. So kann die dritte Oberwelle bei einem Versetzungswinkel $\alpha = 60°$ gefiltert werden Durch ein Aneinanderreihen von mehreren Pinningrichtungen können mehrere Oberwellen gefiltert werden. Die Gesamtvorzugsrichtung der Messbrücke wird dadurch in Richtung eines Winkels $\alpha/2$ verändert, wie dies das Vektordiagramm der Fig. 2 darstellt. Wie in dem Vektordiagramm der Fig. 2 dargestellt, ergibt sich in jeder Brückenwiderstandsanordnung R11-R12, R21-R22, R31-R32 und R41-R42 der Gesamtmessbrücke, die sich jeweils aus einer Reihenschaltung zweier Teilwiderstände RX1-RX2 mit verschiedenen magnetfeldsensitiven Vorzugsrichtungen zusammensetzt, eine Vorzugsrichtung Rres des Brückenzweigs, die der Richtung der Winkelhalbierenden α/2 des Abweichungswinkel α der beiden Widerstände RX1-RX2 entspricht. Da alle Brückenwiderstände dieselbe Vorzugsrichtung in positiver bzw. negativer Richtung im oberen bzw. unteren Halbbrückenzweig aufweisen, weist die Gesamtempfindlichkeitsrichtung der Gesamtbrücke in Richtung Rres. Diagonale Brückenwiderstände haben identische Ausrichtungen der Vorzugsrichtungen der Teilwiderstände und des Gesamtwiderstands.

Es ist denkbar, dass jedes dieser beiden Teilwiderstände nochmal unterteilt wird und sich wieder aufspaltet in zwei Elemente, deren Pinningrichtungen sich um einen Winkel β unterscheiden. In der Regel erfolgen weitere Aufspaltungen symmetrisch in einen positiven und negativen Winkelbetrag um die Vorzugswinkelrichtung, so dass sich diese nicht weiter ändert. Dadurch kann auch die 180°/β-ste Oberwelle gefiltert werden. Die Aufspaltung kann fortgesetzt werden und so können theoretisch beliebig viele Oberwellen gefiltert werden, wobei die Anzahl der weiteren Teilwiderstände jeweils um einen Faktor Zwei steigt und somit eine hohe Anzahl von Teilwiderständen und eine exakte Ausrichtung und identische Widerstandsgröße erforderlich ist.

DE 198 39 450, US 2013/099783, DE 44 38 715, US 2002/006017 und US 2008/272771 beschreiben weitere magneto-resistive Messbrücken. Nach wie vor ist es so, dass innerhalb jedes Brückenzweigs die Oberwellenfilterung angelegt wird. Dadurch, dass jeder einzelne Brückenzweig die gleiche Anzahl von Oberwellen filtert, ist auch die Brückenspannung von diesen Oberwellen gefiltert. Die Anzahl der benötigten Pinningrichtungen in einer Brücke verdoppelt sich dabei mit jedem Filter. So hat man 2 Pinningrichtungen in der Originalkonfiguration ohne Filter (siehe Abb.1). Mit einem Filter für eine Oberwelle hat man dann 4 Pinningrichtungen (siehe Abb.2). Jeder Brückenzweig benötigt mindestens vier Sensorelemente, d.h. Teilwiderstände. Filtert man zwei Oberwellen, so erhält man insgesamt 8 Pinningrichtungen. Jeder Brückenzweig enthält dann mindestens acht Sensorelemente. Die komplette Brücke benötigt dabei mindestens 16 Sensorelemente. Ein Sensor, der aus zwei Brücken besteht, benötigt insofern mindestens 32 Sensorelemente.

Eine weitere Anforderung eines hochgenauen magnetoresistiven Winkelsensors ergibt sich dadurch, dass der Gesamtwiderstand der Messbrücke einerseits einen gewissen Wert annehmen sollte, um optimal ausgewertet zu werden und einen Messstrom in einem gewünschten Bereich beeinflussen zu können, und dadurch, dass der Widerstandswert jeder einzelnen Brückenwiderstandsanordnung im magnetfeldfreien Zustand und die diesen zusammensetzenden Teilwiderstände nominell identische Widerstandswerte annehmen sollten. Fertigungstechnisch ist dies in den meisten Fällen nur schwer oder gar nicht erreichbar, so dass weiterhin die gewünschten trigonometrischen Verläufe der Messsignale und eine optimale Auswertung nicht erreicht werden können. Daher ist es wünschenswert, jede Widerstandsanordnung und den Gesamtwiderstand der Messbrücke im Fertigungsprozess oder nachträglich beeinflussen zu können, um insbesondere Toleranzen in der Fertigung entgegenzuwirken. Diagonale Brückenwiderstände sind identisch ausgelegt und es wird eine Vielzahl verschiedener Pinningrichtungen benötigt, um Oberwellen effektiv zu reduzieren.

Nachteilig am Stand der Technik ist, dass eine Filterung von Oberwellen mittels magnetoresistiver Widerstandsanordnungen nur mit hoher fertigungstechnischer Komplexität erreichbar ist. Des Weiteren kann eine Homogenisierung des Widerstandsverhaltens insbesondere von TMR- oder GMR-basierten Widerstandsanordnungen nur schwer eingehalten werden, da die Widerstandswerte in der Produktion stark streuen können.

Aufgabe der vorliegenden Erfindung ist es, eine Widerstandsanordnung für einen magnetoresistiven Winkelsensor vorzuschlagen, der eine verbesserte Oberwellenfilterung und eine hochgenaue Winkelauflösung bei einem verringerten Fertigungsaufwand und Schaltungskomplexität erreicht.

Diese Aufgabe wird durch einen Winkelsensor nach den unabhängigen Ansprüchen gelöst. Vorteilhafte Ausbildungen der Erfindung sind Gegenstand der Unteransprüche.

OFFENBARUNG DER ERFINDUNG

Erfindungsgemäß wird eine magnetoresistive Wheatstone-Messbrücke vorgeschlagen, die zwei zwischen einer Versorgungspotential Vb parallel geschaltete Brückenzweige umfasst, wobei in jedem Brückenzweig zwei in Reihe geschaltete Widerstandsanordnungen R1 und R3 bzw. R2 und R4 mit einer zwischenliegenden resultierenden Differenzspannung Vout angeordnet sind. Die Widerstandsanordnungen R1 und R4 bzw. R2 und R3 der beiden Brückenzweige liegen diagonal gegenüber und zumindest zwei magnetoresistive Widerstandsanordnung R1, R2, R3, R4 weisen eine magnetisch sensitive Vorzugsrichtung auf. Die Vorzugsrichtungen diagonal gegenüberliegender magnetoresistiver Widerstandsanordnungen der Brückenzweige R1 und R4 bzw. R2 und R3 weichen um einen Winkel ungleich 0° oder 180° voneinander ab.

Diese Erfindung beschreibt somit eine Methode, wie die Oberwellen reduziert und optimale Widerstandswerte erreicht werden können. Im Gegensatz zum Stand der Technik werden Oberwellen nicht in den einzelnen Widerstandsanordnungen unterdrückt, sondern über ein funktionales Zusammenwirken unterschiedlicher magnetischer Vorzugsrichtungen aller Brückenwiderstandsanordnungen in der gesamten Messbrücke unterdrückt. Dadurch wird das Signal verbessert und die Auflösung des Sensors verbessert, wobei eine geringere Anzahl von Teilwiderständen genutzt werden kann. Bei einem Winkelsensor kann dadurch die Winkelgenauigkeit erhöht werden. Die Filterung von Oberwellen einer magnetoresistiven Widerstandsbrücke wird durch die Festlegung der Vorzugsrichtungen Rres1 und Rres2 der diagonal gegenüberliegenden Widerstandsanordnungen der Messbrücke ermöglicht, wobei die Gesamtempfindlichkeitsrichtung Rres sich durch eine Vektoraddition von Teilvorzugsrichtungen Rres1 und Rres 2 diagonaler Widerstandsanordnungen R2 und R3 bzw. R1 und R4 ergibt. Die Anzahl und Ausrichtungen der magnetoresistiven Teilwiderstände jeder Widerstandsanordnung in den beiden Brückenzweigen sind durch die Oberwellenfilterung bedingt, die Gesamtvorzugsrichtung ergibt sich als deren Resultierende. Keine Brückenwiderstandsanordnung weist eine Vorzugsrichtung auf, die mit der Gesamtvorzugsausrichtung der Messbrücke übereinstimmt, und die Widerstandsanordnungen der beiden Halbbrücken weisen verschiedene Einzelvorzugsrichtungen und Vorzugsrichtungen auf.

Die Vorzugsrichtungen der Brückenwiderstände einer Halbbrücke bedingt keine gleichgerichtete Ausrichtung der Vorzugsrichtungen der Brückenwiderstände der jeweils anderen Halbbrücke, im Gegensatz zum Stand der Technik, die eine Identität der Vorzugsrichtungen sich kreuzweise gegenüberliegender Brückenwiderstände R1-R4 sowie R2-R3 fordert.

In einer vorteilhaften Weiterbildung können magnetische Vorzugsrichtungen in Reihe geschalteten Widerstandsanordnungen R1 und R3 bzw. R2 und R4 jedes Brückenzweigs antiparallel ausgerichtet sein. Die magnetischen Vorzugsrichtungen von zwei in Reihe geschalteter Widerstandsanordnungen R1-R3, R2-R4 jedes Brückenzweigs sind antiparallel zueinander ausgerichtet, d.h. um 180° gedreht. Hierdurch wird eine maximal hohe Sensorempfindlichkeit erreicht, auch können die Widerstände jedes Brückenzweigs eng benachbart auf einem Chipsubstrat angeordnet und mit einer antiparallelen Vorzugsrichtung hergestellt werden.

In einer vorteilhaften Weiterbildung kann die Vorzugsrichtung der in den Brückenzweigen jeweils paarweise gegenüberliegenden Widerstandsanordnungen R1 und R2 bzw. R3 und R4 antiparallel ausgerichtet sein. Die Vorzugsrichtung jeweils paarweise benachbarter, in beiden Brückenzweigen liegender Widerstandsanordnungen R1, R2 sowie R3, R4 können antiparallel ausgerichtet sein, In diesem Fall sind die Vorzugsrichtungen der in Reihe liegenden Widerstandsanordnungen R1-R3 sowie R2-R4 abgewinkelt zueinander, so dass auch die jeweiligen diagonal liegenden Widerstandsanordnungen R1-R4 sowie R2-R3 zueinander abgewinkelte Vorzugsrichtungen aufweisen.

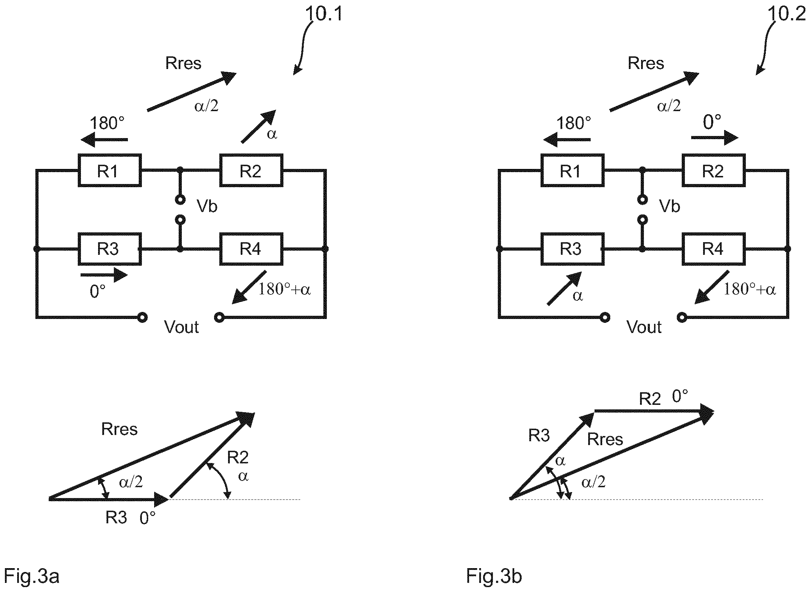

Ist eine Messbrücke nach einer der vorgenannten Ausführungsformen konzipiert, so lässt sich die Gesamtvorzugsrichtung durch Superposition der vektoriellen Vorzugsrichtungen diagonaler Widerstandsanordnungen ermitteln. Dabei kann jeweils eine Vorzugsrichtung einer Widerstandsanordnung jedes Brückenzweigs in einer 0°-Hauptachse liegen, wie Sie z.B. in Fig. 1 in der Messbrücke 100 definiert ist, und die Vorzugsrichtung der jeweils anderen, in Reihe geschaltete Widerstandsanordnung jedes Brückenzweigs kann abgewinkelt sein, bevorzugt in einem 30°, 36°, 45° oder 60°-Winkel abgewinkelt sein. Ein 60°-Winkel dient zur Filterung der 3. Oberwelle, ein Wert von 45° zur Filterung der 4. Oberwelle, ein Wert von 36° zur Filterung der 5. Oberwelle und 30° der Filterung der 6. Oberwelle. Daraus ergibt sich eine resultierende Vorzugsrichtung der Messbrücke, die gegenüber der ursprünglichen 0°-Hauptachse abgewinkelt ist. Diese Hauptachse kann als eine Hauptsymmetrieachse der Widerstandsanordnungen auf einem Chipsubstrat angesehen werden. Nach der Erfindung weicht die Empfindlichkeitsrichtung von dieser Hauptachse ab. Aus fertigungstechnischen Gründen kann es erwünscht sein, die Vorzugsrichtung entsprechend einer geometrischen Vorgabe auf dem Chipsubstrat einzustellen, beispielsweise parallel zu einer Substratkante oder entlang eines Strukturelements auf dem Chipsubstrat, beispielsweise entlang einer Magnetfeldrichtung eines Kompensationsmagnetfeldes einzustellen, dass von einer stromdurchflossenen Spule oder Leiter bereitgestellt werden kann. Zu einer derartigen Einstellung einer Vorzugsrichtung kann die räumliche Anordnung der Gesamtmessbrücke auf dem Chipsubstrat entsprechend gewählt werden. Allerdings kann auch unabhängig von der räumlichen Lage der Widerstandsanordnungen der Messbrücke auf dem Chipsubstrat die Vorzugsrichtungen aller Widerstandsanordnungen gleichsinnig gedreht werden, um eine gewünschte Vorzugsrichtung zu erreichen. So kann es vorteilhaft möglich sein, gegenüber der vorgenannten 0°-Hauptachse eine symmetrische Abwinkelung der Vorzugsrichtung aller Widerstandsanordnung in positiver und negativer Winkelrichtung vorzusehen. Ausgehend von einem Winkel, den die Gesamtvorzugsrichtung gegenüber 0° einer aus dem Stand der Technik bekannten Messbrücke abweicht, können vorteilhaft die beiden Winkel der Vorzugsrichtungen jeweils diagonal gegenüberliegender Widerstandsanordnung R1 und R4 bzw. R2 und R3 um den positiven Vorzugsrichtungswinkel für R2 gegenüber 0° und dem entsprechenden negativen Vorzugsrichtungswinkel für R3 gegenüber 0° und um diesen negativen Vorzugsrichtungswinkel für R1 und diesen positiven Vorzugsrichtungswinkel für R4 gegenüber 180° gedreht sein. Alternativ hierzu können die beiden Winkel der Vorzugsrichtungen jeweils diagonal gegenüberliegender Widerstandsanordnungen R1 und R4 bzw. R2 und R3 von der 0°-Hauptachse um diesen positiven Vorzugsrichtungswinkel für R3 und negativen Vorzugsrichtungswinkel für R2 gegenüber 0° und diesem negativen Vorzugsrichtungswinkel für R1 und diesem positiven Vorzugsrichtungswinkel für R4 gegenüber 180° gedreht sein. Ist z.B. die Vorzugsrichtung der Widerstandsanordnung R1 in eine -180° und R3 in eine 0° Richtung ausgerichtet, und die Vorzugsrichtung von R2 beträgt $\alpha$ und von R4 180°+$\alpha$, wie dies in Fig. 3a dargestellt ist, so ergibt sich ein Winkel der Gesamtvorzugsrichtung Rres entlang einer Achse in $\alpha/2$-Richtung. Werden die Vorzugsrichtungen R1 in 180°-$\alpha/2$, R2 in $\alpha/2$, R3 in -$\alpha/2$ und R4 in 180°+$\alpha/2$ Richtung gedreht, so ergibt sich die Ausrichtung der Gesamtvorzugsrichtung wieder entlang der 0°-Achse. Somit kann bei gegebener räumlicher Lage der Widerstandsanordnungen auf einem Chipsubstrat eine Oberwellenfilterung und eine frei wählbare Einstellung der Richtung der Vorzugsrichtung erreicht werden. Insbesondere kann $\alpha$=60°

gewählt werden. Dabei kann unabhängig von der räumlichen Anordnung der Widerstandsanordnungen auf dem Chipsubstrat die Vorzugsrichtung der Messbrücke eingestellt werden. die sich somit entlang einer Mittellinie einer spiegelsymmetrischen Vorzugsrichtungsverteilungen der diagonalen Widerstandsanordnungen ergibt.

In einer vorteilhaften Weiterbildung kann das betragsmäßige Widerstandsverhalten jeder Widerstandsanordnungen R1, R2, R3, R4 zumindest im magnetfeldfreien Zustand identisch sein. Vorteilhaft ist, dass die Widerstandsgröße der Teilwiderstände R1X, R2X, R3X und R4X gleich bzw. identisch ist und die Widerstandsgröße der Brückenwiderstände gleich sind, so dass eine exakte Einstellung der Gesamtvorzugsrichtung und entsprechend eine genaue Eichung der Messbrücke möglich ist.

In einer vorteilhaften Weiterbildung können die magnetoresistiven Widerstandsanordnungen AMR-, GMR-, oder TMR-Widerstandsanordnungen sein, die auf einem Chipsubstrat angeordnet sind. Die Prozessverfahren zur Herstellung derartiger Chipsubstrate kann kostengünstig mit hoher Genauigkeit erreicht werden, wobei daraus hervorgehende Messbrückenanordnungen eine exakt definierbare Vorzugsrichtung genau aufweisen.

Es kann genügen, dass lediglich zwei diagonal gegenüberliegende Widerstandsanordnungen magnetoresistive Widerstände umfassen und die übrigen beiden Widerstandsanordnungen ohmsche Widerstände darstellen. In einer vorteilhaften Weiterbildung kann jede Widerstandsanordnung R1, R2, R3, R4 einen magnetoresistiven Widerstand mit einer Vorzugsrichtung umfassen, wobei die Vorzugsrichtungen diagonal gegenüberliegender Widerstandsanordnungen der Brückenzweige R1 und R4 bzw. R2 und R3 um einen Winkel $\alpha$ voneinander abweichen, insbesondere um einen Winkel $\alpha$=60° bei TMR- oder GMR-Widerständen bzw. $\alpha$=30° oder $\alpha$=36° bei AMR-Widerständen. Somit wird eine Optimierung der Messbrücke erreicht und alle Widerstandsanordnungen können mit demselben Herstellverfahren und unterschiedlichen Vorzugsrichtungen hergestellt werden.

In einer vorteilhaften Weiterbildung kann jede Widerstandsanordnung R1, R2, R3, R4 zumindest zwei magnetoresistive Widerstände RX1, RX2 mit gegeneinander um einen Winkel $\alpha$2 oder um weitere Winkel versetzten Vorzugsrichtungen umfassen, wobei die resultierenden Vorzugsrichtungen der beiden oder mehreren magnetoresistiven Widerstände diagonal gegenüberliegender Widerstandsanordnungen der Brückenzweige R1 und R4 bzw. R2 und R3 um einen Winkel $\alpha$1 voneinander abweichen, wobei bevorzugt $\alpha$1=60° und $\alpha$2=30° oder $\alpha$2=36°beträgt. Hierdurch kann eine Filterung mehrerer Oberwellenkomponenten durch ein Vorsehen von zwei oder mehreren Teilwiderständen mit verschiedenen Vorzugsrichtungen, die sich nach der zu filternden Oberwelle richten können, in einer Widerstandsanordnung RX der Messbrücke erreicht werden. Ein Wert von 36° dient insbesondere zur Filterung einer fünften Oberwelle.

In einer vorteilhaften Weiterbildung kann zumindest in einer Widerstandsanordnung R1, R2, R3 oder R4 ein Trimmwiderstand RXT in Reihe geschaltet sein, der bevorzugt so gewählt ist, dass ein betragsmäßig gleiches Widerstandsverhalten der Widerstandsanordnungen R1, R2, R3 und R4 gegeben ist. Hierdurch können identische Nominalwerte der Widerstände erreicht und somit im Vorhinein ein Abgleich der Messbrücke und eine definierte Einstellung der Gesamtvorzugsrichtung erreicht werden. Ein eingeschalteter Trimmwiderstand in einer Trimmwiderstandsanordnung ermöglicht einerseits den Abgleich der Widerstandsgröße jeder Widerstandsanordnung, so dass die nominale Widerstandsgröße jeder Widerstandsanordnung identisch ist. Andererseits ermöglicht die Einführung von Trimmwiderständen, bei einer Serienfertigung mehrerer Wafer, auf deren Chipsubstraten Messbrücken aufgebaut sind, das Widerstandsverhalten der Messbrücken verschiedener Wafer anzupassen, so dass eine Homogenisierung der Fertigungsqualität innerhalb jeder Widerstandsbrücke, aber auch über eine Reihe von Widerstandsbrücken hinweg gewährleistbar ist. Insbesondere bei der TMR- oder GMR-Technologie können Widerstandswerte aufgrund kleinster Prozessvariationen deutlich streuen, so dass mittels Trimmwiderstände fertigungsbedingte Abweichungen korrigiert werden können.

In einer vorteilhaften Weiterbildung kann der Trimmwiderstand ein magnetoresistiver Widerstand sein, der eine Trimmwiderstands-Vorzugsrichtung aufweist, insbesondere kann der Trimmwiderstand ein TMR-Widerstand sein. Bei Herstellung von TMR-Chipsubstraten kann prozesstechnisch eine hohe Streuung des Widerstandsverhaltens auftreten, wobei die Trimmwiderstände die Möglichkeit eröffnen, ein identisches Nominalverhalten des Widerstands und somit einen Abgleich der Messbrücke zu erreichen.

In einer vorteilhaften Weiterbildung kann eine Trimmwiderstands-Vorzugsrichtung in Richtung einer Vorzugsrichtung eines Widerstands der Widerstandsanordnung, in Richtung der resultierenden Vorzugsrichtung der Widerstandsanordnung in einem Brückenzweig oder in Richtung der Gesamtvorzugsrichtung der Wheatstone-Messbrücke ausgerichtet sein. Pro Brückenwiderstandsanordnung RX kann ein Trimmwiderstand RXT vorgesehen sein, dessen Vorzugsrichtung in der Vorzugsrichtung des Brückenwiderstands RX eines Brückenzweigs bzw. der Halbbrücke RresX liegt, oder ein Trimmwiderstand RT, dessen Vorzugsrichtung in der Gesamtvorzugsrichtung Rres liegt. Somit kann der Gesamtwiderstand der Messbrücke eingestellt und fertigungstechnisch bedingte Toleranzen der Messbrückenwiderstände, d.h. der vier Widerstandsanordnungen untereinander ausgeglichen werden.

In einer vorteilhaften Weiterbildung kann der Trimmwiderstand eine Aneinanderreihung von zumindest zwei Tunnelwiderständen zwischen Top-Elektroden und Bottom-Elektroden umfassen, wobei der Trimmwiderstand durch eine Elektrodenunterbrechung der Top-Elektrode oder der Bottom-Elektrode einstellbar sein kann. Auch können Top-Elektroden miteinander kurzgeschlossen werden, um den Widerstandswert zu verändern. Dadurch können Serien- oder Parallelschaltungen von Trimmwiderständen gebildet werden, um den Widerstandswert und ggf. die Vorzugsrichtung einer Widerstandsbrückenanordnung anzupassen. Hierdurch kann durch im Fertigungsverfahren ohnehin eingesetzte Techniken eine hohe Anzahl von Trimmwiderständen bereitgestellt werden, um einen sehr feinen Abgleich der Widerstände zu ermöglichen.

In einer vorteilhaften Weiterbildung kann der Trimmwiderstand eine Reihen- und/oder eine Parallelschaltung mehrerer Teiltrimmwiderstände, insbesondere mehrerer Tunnelwiderstände umfassen, wobei die Anzahl der Parallelzweige und/oder der Reihenwiderstände jedes Parallelzweigs einstellbar sein kann. Trimmwiderstände können als Reihen- und/oder Parallelschaltung von einer Mehrzahl von gleichausgerichteten Teilwiderständen aufgebaut sein, wobei diese kurzgeschlossen oder in einen Parallelzweig aufgetrennt sein können, um den Widerstandswert zu verkleinern. Somit kann eine sehr feine Einstellung für einen exakten Abgleich einer Messbrücke erreicht werden.

In einem nebengeordneten Aspekt wird ein Winkelsensor vorgeschlagen, der zumindest zwei der vorgenannten, um einen vordefinierten Winkel, insbesondere um 90° versetzte magnetoresistive Wheatstone-Messbrücken zur Bestimmung einer Winkelausrichtung eines Magnetfeldes mittels einer ersten und einer zweiten Sensorbrücke, insbesondere einer Sinusbrücke und einer Kosinusbrücke umfasst. Es können auch drei oder mehrere Messbrücken umfasst sein, die insbesondere in alle drei Raumrichtungen abgewinkelt zueinander sind, um einen 3D-Magnetfeldsensor herzustellen. Der Winkel bestimmt eine mathematische Beziehung zwischen den Ausgangssignalen der Messbrücken, um eine Ausrichtung eines externen Magnetfelds zu ermitteln. Im Falle einer 90°-Abwinkelung kann eine einfache ARCTAN-Funktion der beiden Ausgangswerte Vout zur Ermittlung eines Messwinkels genutzt werden.

In einer vorteilhaften Weiterbildung des Winkelsensors können Teilwiderstände R1X und R3X der Widerstandsanordnungen R1, R3 des ersten Brückenzweigs R1-R3 auf einem Chipsubstrat räumlich benachbart angeordnet sein, sowie Teilwiderstände R2X, R4X der Widerstandsanordnungen R2, R4 des zweiten Brückenzweigs R2-R4 auf dem Chipsubstrat räumlich benachbart angeordnet. Die ersten und zweiten Brückenzweige R1-R3 und R2- R4 jeder Sensorbrücke können diagonal zueinander auf dem Chipsubstrat angeordnet sein. Somit liegen die Widerstandsgruppen der beiden Brückenzweige diagonal zueinander und benachbart zu Brückenzweigen einer vorteilhafterweise um 90° verdrehten Messbrücke. So können die Widerstandsanordnungen einer Sinus- und eine Kosinusbrücke platzsparend in einem 4-Quadrantenfeld kreuzweise zueinander angeordnet sein. Hierdurch wird ein platzsparendes und offsetarmes Design für einen Winkelsensor erreicht. Durch die enge räumliche Nähe der Widerstandsanordnungen der Messbrücke können sich fertigungstechnische Streuungen gegenseitig kompensieren und eine hohe Genauigkeit des Sensors erreicht werden kann.

ZEICHNUNGEN

Weitere Vorteile ergeben sich aus der vorliegenden Zeichnungsbeschreibung. In den Zeichnungen sind Ausführungsbeispiele der Erfindung dargestellt. Die Zeichnung, die Beschreibung und die Ansprüche enthalten zahlreiche Merkmale in Kombination.

Der Fachmann wird die Merkmale zweckmäßigerweise auch einzeln betrachten und zu sinnvollen weiteren Kombinationen zusammenfassen.

Es zeigen:

**Fig. 1** eine Wheatstone-Messbrücke eines Winkelsensors des Stands der Technik;

**Fig. 2** eine Wheatstone-Messbrücke eines Winkelsensors des Stands der Technik;

**Fig. 3** eine erste Ausführungsform einer Wheatstone-Messbrücke für einen erfindungsgemäßen Winkelsensor;

**Fig. 4** eine zweite Ausführungsform einer Wheatstone-Messbrücke für einen erfindungsgemäßen Winkelsensor;

**Fig. 5** ein Fehlerdiagramm von Winkelsensoren beim Einsatz verschiedener Messbrückenkonfigurationen;

**Fig. 6** ein Chiplayout einer Ausführungsform eines erfindungsgemäßen Winkelsensors;

**Fig. 7** Schnittdarstellung von Trimmwiderständen zum Einsatz in einem erfindungsgemäßen Winkelsensor;

**Fig. 8** Draufsicht auf Trimmwiderstände zum Einsatz in einem erfindungsgemäßen Winkelsensor;

**Fig. 9** eine dritte und vierte Ausführungsform einer Wheatstone-Messbrücke für einen erfindungsgemäßen Winkelsensor ;

**Fig. 10** eine fünfte und sechste Ausführungsform einer Wheatstone-Messbrücke für einen erfindungsgemäßen Winkelsensor;

**Fig. 11** eine siebte Ausführungsform einer Wheatstone-Messbrücke für einen erfindungsgemäßen Winkelsensor;

**Fig. 12** eine achte Ausführungsform einer Wheatstone-Messbrücke für einen erfindungsgemäßen Winkelsensor.

In den Figuren sind gleichartige Elemente mit gleichen Bezugzeichen beziffert. Die Figuren zeigen lediglich Beispiele und sind nicht beschränkend zu verstehen.

Nachfolgend wird durch die Figuren das erfindungsgemäße Konzept beschrieben, das mit weniger Sensorelementen auskommt, aber vergleichbare und überlegenere Filtereigenschaften zeigt, wie die aus dem Stand der Technik bekannten Designs. Wesentlicher Aspekt ist, dass die Filterung nicht in jedem eigenen Brückenzweig oder in einzelnen Brückenwiderstandsanordnungen komplett vorgesehen wird, sondern über die vier Widerstandsanordnungen verteilt ist.

Nachfolgend werden als magnetoresistive Widerstandselemente pinnbare Widerstände betrachtet, die wie bei GMR- oder TMR-Widerständen eine magnetische Vorzugsrichtung in Pinnrichtung aufweisen. Bei AMR- Widerstandstypen gibt es keine Pinningrichtung. Das entsprechende Analogon zur Pinningrichtung ist hier die Streifenrichtung, die die Richtung des Stromflusses vorgibt. Somit können die weiteren Ausführungen sinngemäß angewendet werden. Bei AMR sind typischerweise die halben Winkelbeträge anzunehmen.

In den Figuren 1 und 2 sind magnetoresistive Messbrücken 100, 102 dargestellt, die aus dem Stand der Technik bekannt sind, und die in der Einleitung bereits diskutiert wurden. Diagonal angeordnete Brückenwiderstände weisen identische magnetische Vorzugsrichtungen auf, die durch einen Pfeil symbolisiert sind, und in deren Richtung die höchste Empfindlichkeit und größte Widerstandsänderung bei Variation eines externen Magnetfelds erreicht ist. Die Vorzugsrichtungen der Brückenwiderstände eines Brückenzweigs sind jeweils um 180° gegeneinander gedreht. Somit kann nur mit hohem fertigungstechnischen Einsatz und großer Bauteilzahl und Chipgröße eine Oberwellenfilterung und (lineare) Winkelerfassungsgenauigkeit erreicht werden.

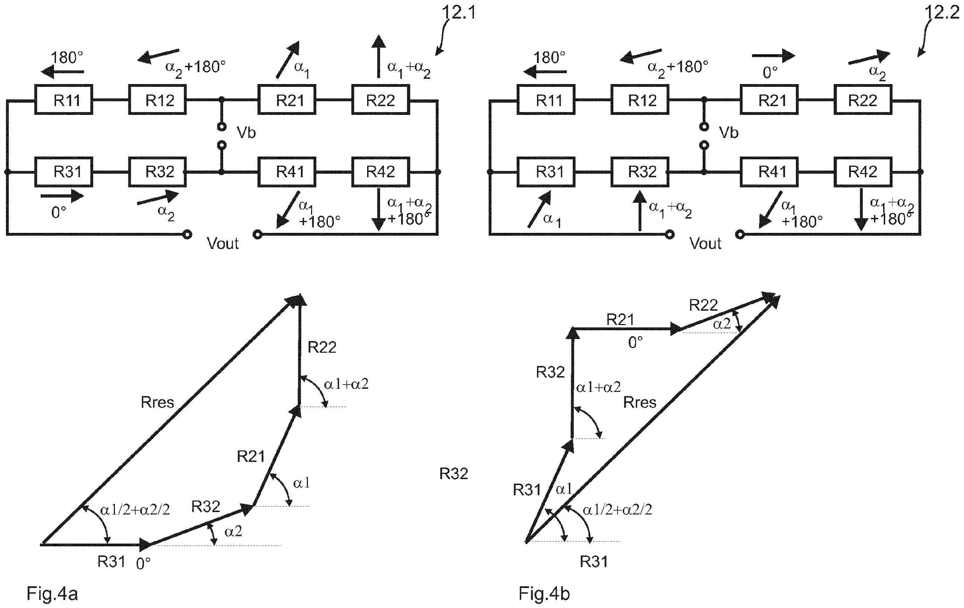

Die Figs. 3 und 4 zeigen jeweils zwei Ausführungsbeispiele von magnetoresistiven Wheatstone-Messbrücken zum Einsatz in einem Winkelsensor der Erfindung. Die Fig. 3a und Fig. 3b zeigen einfache Widerstandsbrücken 10.1 bzw. 10.2 mit einem einzelnen Brückenwiderstand in jeder Brückenwiderstandsanordnung. Die magnetoresistiven Widerstandsanordnungen der Brückenzweige bzw. einer Halbbrücke, die mit dem gleichen Ausgangs-Anschluss Vout verbunden sind, weisen jeweils eine antiparallele Pinningrichtung / Vorzugsrichtung auf. In Fig. 3a sind R1 und R3 in einem Brückenzweig an einem Anschluss Vout verbunden und haben eine antiparallele Pinningrichtung. Ebenso sind R2 und R4 in einem Brückenzweig an einen anderen Anschluss Vout verbunden und weisen zueinander ebenfalls eine antiparallele Pinningrichtung auf. Diagonale Brückenwiderstände R1 und R4 bzw. R3 und R2 weisen Vorzugsrichtungen auf, die um einen Winkel $\alpha$ zueinander gedreht sind. Diese Anordnung bewirkt eine Filterung der Brückensignale. Dabei wird die 180°/$\alpha$-te Oberwelle unterdrückt. In jedem Brückenzweig weisen die jeweiligen Widerstandsanordnungen einen Winkelversatz von 180° auf, wobei sich gegenüberliegende Widerstandsanordnungen jedes Brückenzweigs einen Winkelversatz von 180°-$\alpha$ aufweisen. Der Vorteil liegt auf der Hand. Diese Oberwellenfilterung benötigt für einen ähnlichen Filtereffekt nur die halbe Zahl an Sensorelementen.

In Fig. 3a weisen die in Reihe geschalteten Widerstandsanordnungen R1 und R3 einer Halbbrücke sowie R2 und R4 der korrespondierenden zweiten Halbbrücke jeweils zueinander antiparallele Vorzugsrichtungen auf. Die Vorzugsrichtungen der Widerstandsanordnungen R1 und R2 sowie R3 und R4 sind jeweils um den Winkel $\alpha$ zueinander verdreht.

Demgegenüber ist in der Fig. 3b eine Messbrücke 10.2 dargestellt bei der in der Reihenschaltung der Widerstandsanordnungen R1 und R3 einer Halbbrücke sowie R2 und R4 der korrespondierenden zweiten Halbbrücke die Vorzugsrichtungen der Widerstandsanordnungen jeweils um den Winkel $\alpha$ zueinander verdreht. Die Vorzugsrichtungen der paarweise gegenüberliegenden Widerstandsanordnungen R1 und R2 sowie R3 und R4 sind jeweils antiparallel zueinander ausgerichtet. Schaltungstechnisch kann die in Fig. 3a dargestellte Messbrücke 10.1 durch Vertauschen der Versorgungsspannung- und Ausgangsspannungskontakte Vb, Vout in die in Fig. 3b dargestellte Messbrücke 10.2 überführt werden.

In Fig. 3a und Fig. 3b sind durch Vektorgraphen dargestellt, wie die Vorzugsrichtungen bzw. Empfindlichkeitsrichtungen Rres der Gesamtbrücke 10.1 bzw. 10.2 ermittelt werden kann. Eine vektorielle Superposition der Vorzugsrichtungen von R3 und R2, den diagonal gegenüberliegenden Widerstandsanordnungen, erzeugt einen resultierenden Vektor Rres der parallel zur sensitiven Achse, d.h. in die Vorzugsrichtung der Widerstandsbrücke zeigt. Entlang dieser Achse weist die Widerstandsbrücke die höchste Empfindlichkeit auf, wobei Oberwellen unterdrückt werden.

Jede Widerstandsanordnung einer Halbbrücke R1, R3 sowie R2, R4 weist eine Vorzugsrichtung, d.h. Empfindlichkeitsachse auf, wobei die Gesamtvorzugsrichtung Rres der Halbbrücke nicht wie im Stand der Technik der Vorzugsrichtung jedes einzelnen Widerstandsanordnung entspricht, sondern sich in eine Richtung $\alpha/2$ der Ausrichtung der Vorzugsrichtungen diagonaler Widerstandsanordnungen, die um $\alpha$ voneinander abweichen, ergibt. Sind die Halbbrücken wie in Fig. 3a verschaltet, so dass in der Halbbrücke die Vorzugsrichtungen jeweils gleichgerichtete, aber antiparallele Vorzugsrichtungen aufweisen, so wird eine Gesamtvorzugsrichtung Rres der Gesamtbrücke durch eine vektorielle Superposition der Vorzugsrichtungen der diagonalen Widerstandsanordnungen R3 und R2 erreicht. Dieselbe Filterung erreicht man auch, wie in Fig. 3b dargestellt, indem paarweise benachbarte Widerstandsanordnungen R1, R2 bzw. R3, R3 der beiden Brückenzweige antiparallele Vorzugsrichtungen aufweisen, und die Vorzugsrichtungen innerhalb eines Brückenzweigs um den Winkel α abweichen. Somit ergibt sich die Empfindlichkeitsrichtung Rres der Gesamtbrücke 10.1 und 10.2 in den Fällen der Fig. 3a und 3b durch eine vektorielle Superposition der Vorzugsrichtungen der der diagonal gegenüberliegenden Widerstandsanordnungen R3 und R2. Im Gegensatz zum Stand der Technik erfolgt die Oberwellenfilterung durch das Zusammenspiel der Widerstände beider Halbbrücken, und nicht - wie im Stand der Technik bekannt - bereits innerhalb eines Brückenwiderstands.

Durch die erfindungsgemäßen Anordnungen in Figs. 3a und 3b wird die n-te Oberwelle gefiltert, wobei gilt n = 180 / α.

In den Figs. 4a und 4b sind Ausführungsbeispiele einer Messbrücke 12.1 bzw. 12.2 dargestellt, mit der eine weitere Oberwelle gefiltert werden kann. Dies wird dadurch erreicht, indem jede Widerstandsanordnung R1 bis R4 in zwei Teilwiderstände R11, R12, ..., R41, R42 aufgeteilt ist, wobei die Pinningrichtungen der beiden Teilwiderstände RX1 und RX2 um einen Winkel α2 zueinander aufweisen. Die Vorzugsrichtungen diagonaler Widerstandanordnungen sind um den Winkel α1 gegeneinander verdreht. Durch diese Anordnung wird die Oberwelle 180°/ α1 sowie die Oberwelle 180°/ α2 gefiltert. In der Fig. 4a sind in der Messbrücke 12.1 die Vorzugsrichtungen des jeweils oberen und unteren Brückenwiderstands jeder Halbbrücke, R1-R3 bzw. R2-R4 um 180° antiparallel ausgerichtet und die Vorzugsrichtung diagonaler Widerstandsanordnungen um einen Winkel α1 gegeneinander gedreht. In der Fig. 4b sind in der Messbrücke 12.2 die Vorzugsrichtungen der Widerstandsanordnungen jedes Brückenzweigs um α1 gegeneinander verdreht, wobei paarweise gegenüberliegende Widerstandsanordnungen der beiden Brückenzweige antiparallel ausgerichtet sind. Die Schaltungskonfiguration der Messbrücke 12.2 der Fig. 4b ist durch Vertauschen von Vb und Vout aus der Messbrücke 11.1 der Fig. 4a herstellbar. Der Vorteil dieser Anordnung ist wieder evident. Es können zwei Oberwellen gefiltert werden, wie dies das bereits aus dem Stand der Technik bekannte Design aus Fig. 2 leistet, aber es werden im Gegensatz dazu nur 8 Sensorelemente benötigt statt 16, wobei im Stand der Technik innerhalb jedes Brückenwiderstands das Vorhandensein aller Vorzugsrichtungen und der Filterwirkung erforderlich ist. Die Anordnung kann verkleinert und vereinfacht hergestellt und somit kostengünstiger gestaltet werden. In jeder Widerstandsanordnung wird nur ein Teil der möglichen Vorzugsrichtungen realisiert.

In den Vektordiagrammen der Figs. 4a, 4b sind grafisch dargestellt, wie sich die sensitive Achse (Gesamtvorzugsrichtung) Rres der Gesamtbrücke 12.1 bzw. 12.2 ergibt. Da in jeder Halbbrücke beide Brückenwiderstände gleichartig aufgebaut sind und gleiches betragsmäßiges Verhalten zeigen, aber die Winkel der Vorzugsrichtungen jeweils um 180° gedreht sind, allerdings beide Halbbrücken verschiedene Vorzugsrichtungen aufweisen, ergibt sich die Gesamtvorzugsrichtung Rres durch Superposition der Vorzugsrichtungen beider Halbbrücken Rres1 und Rres2 als Zusammenspiel beider Halbbrücken für die Gesamtbrücke.

Der resultierende Vorzugsrichtungswinkel α1/2+α2/2 ergibt sich auf vektoralgebraischem Wege sehr einfach, wie dies das beigefügte Vektorenbild der Vorzugsrichtungen der einzelnen magnetoresistiven Widerstände darstellt und lässt sich mathematisch ausdrücken durch:

$$\frac{\alpha1 + \alpha2}{2} = \arctan\left( \frac{\sin(\alpha1) + \sin(\alpha2) + \sin(\alpha1 + \alpha2)}{1 + \cos(\alpha1) + \cos(\alpha2) + \cos(\alpha1 + \alpha2)} \right)$$

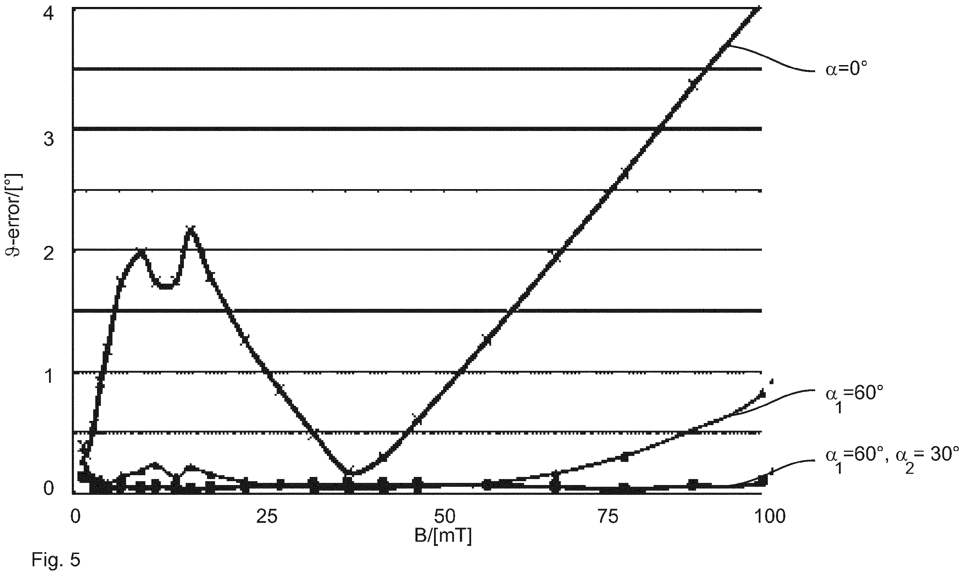

In der Fig. 5 sind durch Simulationen ermittelte Winkelfehler eines TMR-Winkelsensors bestehend aus zwei Messbrücken für verschiedene Flussdichten unter Annahme eins oberwellenbehafteten Erregersignals dargestellt. ϑ-err ist der Winkelfehler, d.h. die Abweichung des vom Winkelsensor ermittelten Fehlers zum wirklichen Winkel ϑ. Dabei wurde der Winkelfehler ϑ-err unter der Annahme berechnet, dass die Phase von Kosinus und Sinus exakt 90° ist, die Amplituden der beiden Brücken exakt identisch sind und der Offset der beiden Brückensignale identisch bei Null liegt. Im Falle α=0° ist der Fehler einer aus dem Stand der Technik eingesetzten Messbrücke nach Fig. 1 dargestellt. α=60° entspricht der Messbrückenanordnung aus Fig. 3 und α1=60° und α2=30° der Messbrückenanordnung aus Fig. 4. Der resultierende Fehler ist durch die Oberwellen im Messaufbau und in der Bewegung der Magnetisierungsrichtung der Referenzschicht hervorgerufen. Es ist offensichtlich, dass die erfindungsgemäßen Filterkonzepte hervorragend funktionieren.

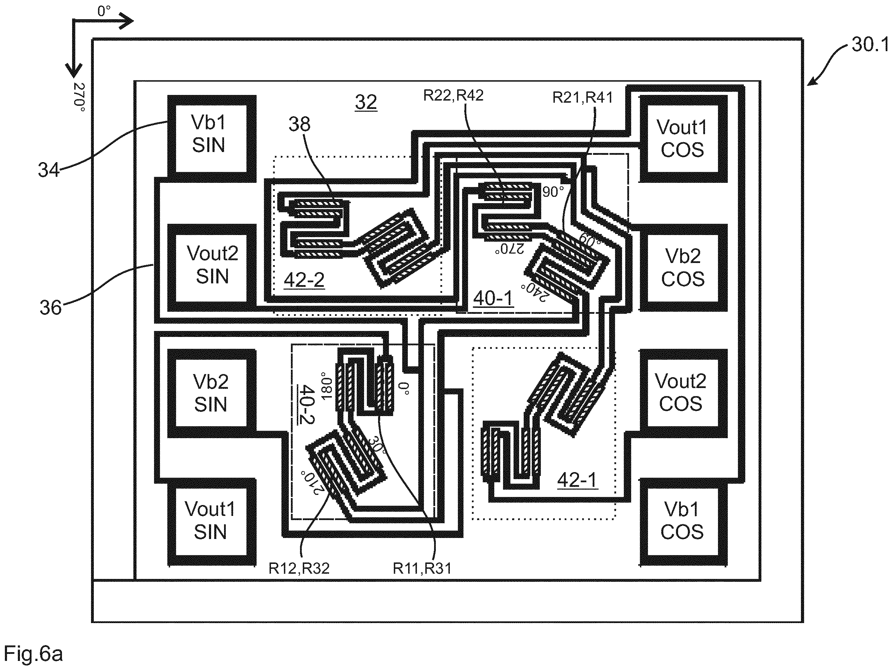

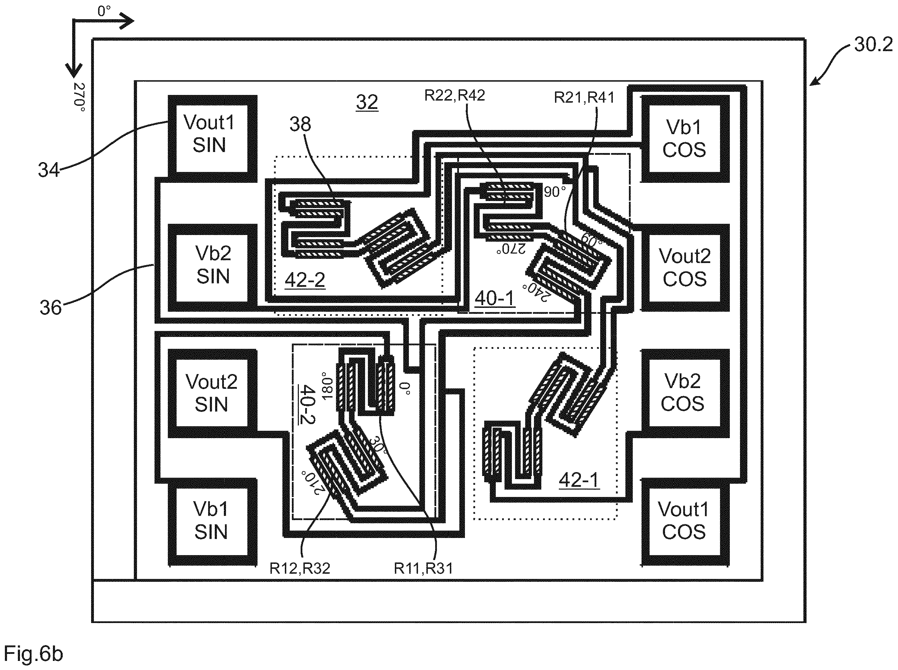

In der Fig. 6a und 6b sind Chiplayouts eines Winkelsensors 30.1 bzw. 30.2 dargestellt, die jeweils identisch aufgebaut sind, allerdings, wie bereits bzgl. der Figs. 3a, 3b und 4a, 4b dargestellt, durch Vertauschen von Versorgungs- und Messabgriffen Vb, Vout ineinander überführbar sind. Die Winkelsensoren 30.1, 30.2 bestehen aus zwei gegeneinander um 90° gedrehten Widerstandsbrücken 40, 42, die nach der in Fig. 4a, Fig. 4b dargestellten Messbrücken 12.1, 12.2 aufgebaut sind. Die Winkel sind mit α1 = 60° und α2=β = 30° gewählt. Die beiden Wheatstonebrücken 40, 42 dienen zur Ermittlung einer Sinus- und einer Kosinuskomponente eines Magnetfelds und sind auf einem Chipsubstrat 32 angeordnet. Dabei sind die jeweiligen antiparallelen Widerstandsanordnungen eines Brückenzweigs R1, R3 40-1 und R2, R4 40-2 sowie R1, R3 42-1 und R2, R4 42-2 jeder Widerstandsbrücke 40, 42 räumlich benachbart angeordnet und die beiden Zweige jeder Brücke 40, 42 diagonal zu einem Mittelpunkt des Chiplayouts auf dem Substrat 32 angeordnet. Hierdurch sind die Brückenzweige der beiden Brücken 40, 42 räumlich benachbart auf dem Chipsubstrat 32 angeordnet. Links auf dem Chipsubstrat 32 sind Pad-Anschlüsse 34 der Sinus-Brücke 40, zwei Pads für die Spannungsversorgung UBSIN und GNDSIN und zwei Pads für den differenziellen Brückenabgriff SIN+ und SIN- vorgesehen. Analog dazu sind rechts die Pads UBCOS und GNDCOS für die Spannungsversorgung sowie COS+ und COS- für den Mittelabriff der Kosinusbrücke 42 vorgesehen. Somit stellen Vb1 SIN und Vb2 SIN die Versorgungsspannungsanschlüsse Vb und Vout1 SIN, Vout2 SIN die beiden Kontakte des Ausgangsanschlusses Vout dar, gleiches gilt sinngemäß für die Kosinusbrücke 42. In der Mitte des Winkelsensorchips 30 befinden sich TMR Elemente. Die TMR Elemente der oberen und unteren Brückenwiderstände 40-1 bzw. 40-2 sind in gestrichelten Rechtecken gruppiert und gehören zur Sinus-Brücke 40, die unteren und oberen Brückenwiderstände 42-1, 42-2 in den gepunkteten Rechtecken zur Kosinusbrücke 42. Die Elemente sind somit in Quadraten zusammengefasst. Für die Sinusbrücke 40 sind in jedem Quadrat die vorhandenen Pinningwinkel bezüglich des oben links dargestellten 2D-Koordinatensystems angegeben und die dazugehörigen Widerstände sind gemäß der Brücke 12 nach Fig. 4 geschaltet. Der Winkelsensor 30.2 der Fig. 6b ist durch Vertauschen der Anschlüsse von Vb und Vout des Winkelsensors 30.1 erreichbar, wobei sich deren Schaltungskonfiguration der einzelnen Messbrücken entsprechend der Darstellungen der Fig. 4b gegenüber Fig. 4a ändert.

Kernpunkt in den Ausführungsbeispielen von magnetoresistiven Brückenkonfigurationen zum Einsatz in einem Winkelsensor ist, dass innerhalb einer Halbbrücke gleiche, allerdings antiparallele Vorzugsrichtungen der beiden Brückenwiderstände vorhanden sind, aber beide Halbbrücken verschieden ausgerichtete Bezugsrichtungen aufweisen, wobei diese zusammen die Gesamtvorzugsrichtung der Messbrücke ergeben. Hierdurch können mit einer verringerten Anzahl von Brückenwiderständen effektiv Oberwellen unterdrückt und ein nahezu perfekter sinus- /kosinusförmiger Ausgangsspannungsverlauf erreicht werden, da nicht jede Vorzugsrichtung einer Oberwelle in jedem Widerstandsanordnung oder jeder Halbbrücke abgebildet sein muss.

Die obigen Vorschläge beruhen darauf, dass die Widerstandsgröße jedes Brückenwiderstands, der wiederum aus mehreren Teilwiderständen in Reihenschaltung zusammengesetzt sein kann, idealerweise identisch gleich groß ist. Fertigungstechnisch ist dies nur schwer erreichbar, da die Widerstandswerte der Brückenwiderstände streuen. Ebenfalls kann es fertigungstechnisch zu einer für alle Widerstände gleichen Widerstandsänderung z.B. von einem Wafer zum nächsten kommen, die zu einem veränderten Gesamtwiderstand der Messbrücke führt, was für die Einbindung in eine Auswerteelektronik nachteilig ist. Daher können durch die Trimmwiderstände sowohl innerhalb einer Messbrücke identische Widerstandsanordnungen geschaffen werden, als auch über mehrere Wafer hinweg ein identisches Messbrückenverhalten erreicht werden.

Daher sind mit den in der Fig. 4a, Fig. 4b und Fig. 6a, Fig. 6b dargestellten Ausführungsbeispielen eine effektive Oberwellenfilterung und eine hohe Genauigkeit der Winkelauflösung erreichbar. Voraussetzung ist allerdings ein betragsmäßig gleiches Verhalten der Widerstandswerte bzgl. einer vorgegebenen Magnetisierung in die Vorzugsrichtung. Nur so kann die Brückenschaltung zur effizienten Oberwellenfilterung genutzt werden. Zusätzlich zur Anordnung mit verschiedenen Pinningrichtungen ist es daher wünschenswert und vorteilhaft, dass Trimmwiderstände RT 50 vorgesehen sind, die es ermöglichen, eine ungleiche Widerstands-Verteilung auf einem Wafer zu minimieren bzw. die Widerstände zu homogenisieren und identische Nominalwerte zu erreichen, bzw. den mittleren Widerstandswert auf einem Wafer zu trimmen. Trimmwiderstände 50 können in Reihe oder parallel zu einem Teilwiderstand oder einer Widerstandsanordnung geschaltet werden, um den Gesamtwiderstandswert und ggf. auch die Vorzugsrichtung anzupassen.

Vor allem bei TMR Sensoren tritt regelmäßig eine stark streuende Widerstandsverteilung auf einem Chipsubstrat auf, da geringste Änderungen der Barrieredicke große Änderungen im Barrierenwiderstand zeigen. Erst mit Trimmwiderständen 50 ist es vorteilhaft möglich, einen Sensor zu bauen, der erstens im Widerstandswert eng spezifiziert werden kann (z.B. Mittelwert $\pm$ 20 %) und zweitens eine gute Winkelgenauigkeit aufweist.

Trimmwiderstände 50 sollten nach Möglichkeit die gleichen Eigenschaften haben, wie die eigentlichen magnetoresistiven Elemente auf dem Chip. Das heißt, die Trimmwiderstände 50 sollten auch AMR- GMR- oder TMR-Elemente sein, die je nach Bedarf dazu geschaltet werden können, bzw. ausgeklammert werden können.

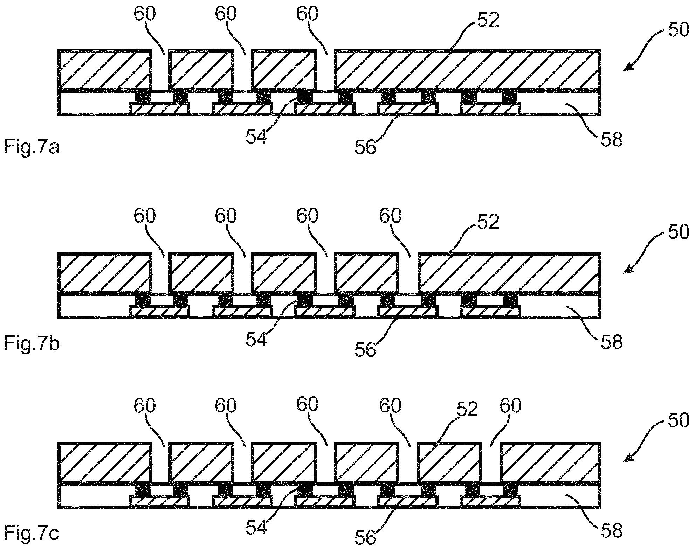

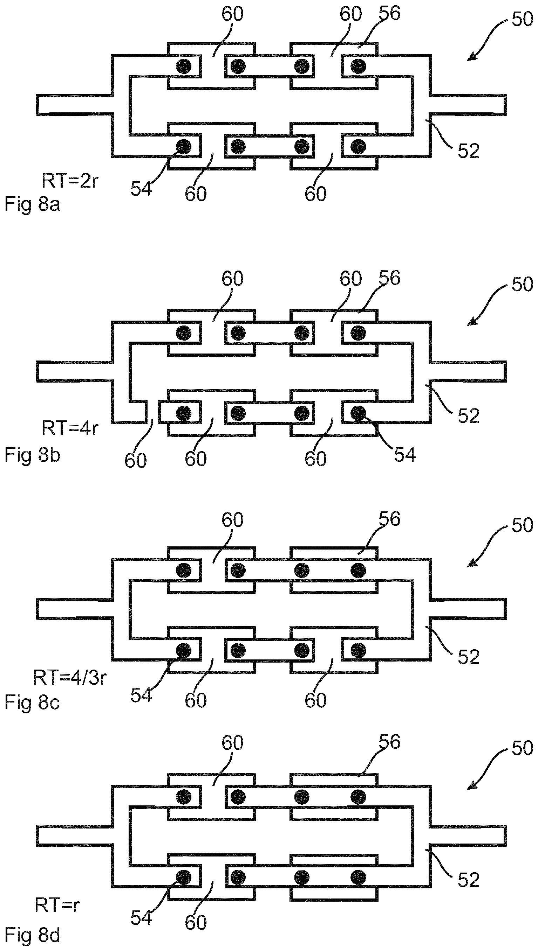

Eine Möglichkeit, Trimmwiderstände 50 auszugestalten, ist in den Figs. 7 und 8 dargestellt. In Fig. 7 liegen 10 identische Tunnelwiderstände 54 vor in Form von 10 Tunnelelementen. Dabei wird der Strom über eine Top-Elektrode 52 eingespeist und fließt durch das Tunnelelement 54 in eine Bottom-Elektrode 56 und dann durch ein zweites Tunnelelement 54 wieder zurück in die Top-Elektrode 52. Bottom-Elektrode 56 und Top-Elektrode 52 sind durch eine Isolationsschicht getrennt.

In Fig. 7a ist gezeigt, dass die vier linken Tunnelelemente 54 nicht zum Gesamtwiderstand RT beitragen, da die Top-Elektrode 52 die vier Tunnelelemente 54 kurzschließt. Hierbei ist zu bemerken, dass die Top-Elektrode 52 typischerweise einen Widerstand hat, der einen Faktor 100 niedriger liegt als der der Tunnelelemente 54.

Stellt man nun fest, dass der mittlere Widerstandswert der Tunnelelemente etwas zu niederohmig ist, z.B.

durch ein Monitoring Tool (CIPT-Verfahren, Current in Plane Tunneling Verfahren - Stromflächenverteilungsmessung), kann man die äußeren Tunnelelemente 54 dadurch zuschalten, dass die Top-Elektrode 52 so geändert wird, dass diese beiden Tunnelelemente 54 wirksam werden. Stellt man nun fest, dass der Trimmwiderstand RT etwas zu hochohmig ist, z.B. durch ein Monitoring CIPT-Verfahren, kann man weitere Tunnelelemente 54 kurzschließen.

Die unterschiedliche Form der Top-Elektrode 52 lässt sich durch unterschiedliche, photolithographische Masken realisieren. Verschiedene Masken können gewählt werden, welche die unterschiedliche Form der Top-Elektrodenlage 54 abbilden. Eine Vormessung ist vorteilhaft, die feststellt, welcher Widerstandswert auf dem aktuellen Wafer vorliegt. Gemäß dieser Vormessung ist es möglich, die passende kompensierende Maske zu wählen, damit die Messbrücke 10, 12, 14, 16, 18 oder 20 am Ende den vorgegebenen Widerstandswert erreicht.

Eine noch feinere Anordnung der Trimmwiderstände 50 ergibt sich aus einer Parallelschaltung von Tunnelwiderständen 54, wie dies in der Fig. 8 verdeutlicht ist. Auf dem Chipsubstrat sind jeweils eine Parallelschaltung zweier Reihen von jeweils vier Tunnelwiderständen 54 vorgesehen, die durch Elektrodenunterbrechungen 60 oder einem Elektrodenkurzschluss in sehr fein einstellbare Trimmwiderstandsgrößen R eingestellt werden können. Von oben nach unten sind folgende Trimmwiderstände 50 realisiert:

Fig. 8a stellt eine Parallelschaltung von jeweils vier in Reihe geschalteten Tunnelwiderständen 54 dar. Der Widerstandswert RT des Trimmwiderstands liegt bei RT=2r, wobei r die Widerstandsgröße eines Tunnelwiderstands 54 entspricht.

Fig. 8b stellt eine Reihenschaltung von vier Tunnelwiderstände 54 dar, da der untere Zweig durch eine Elektrodenunterbrechung 60 abgeschaltet ist. Der Trimmwiderstandswert beträgt RT=4r.

Fig. 8c bildet einen Trimmwiderstand 50 der Größe RT=4/3r aus, da im oberen Zweig zwei Tunnelwiderstände 54 und im unteren Zweig vier Tunnelwiderstände 54 in Reihe geschaltet sind.

Fig. 8d zeigt einen Trimmwiderstand 50 der Größe RT=r, im oberen und unteren Parallelzweig sind jeweils zwei Tunnelwiderstände 54 in Reihe geschaltet.

Verwendet man nun im Sinne der Oberwellenfilterung paarweise Widerstände in jeder Halbbrücke bzw. in jedem Brückenwiderstand, wie dies der Stand der Technik vorschlägt, und wie es trivialerweise die trigonometrischen Formeln vorgeben, so hat das Trimmverfahren den großen Nachteil, dass die Veränderungen der Top-Elektrode auch paarweise gestaltet werden müssen. Beide Widerstände R11 und R12 müssen identisch verändert werden, sonst ist die Oberwellenfilterung nicht korrekt ausgebildet, sondern verzerrt. Das bedeutet, dass mindestens vier Tunnelelemente 54 ergänzt oder kurzgeschlossen werden müssen. Besteht ein Brückenzweig gar aus vier verschiedenen Widerständen mit vier verschiedenen Pinningrichtungen (R11, R12, R13, R14), wie in den Figs. 4, 6 oder 9, so müssen mindestens 8 Tunnelelemente 54 dazu geschaltet bzw. kurzgeschlossen werden. Hat man beispielsweise 16, bzw. 32 bzw. 64 Elemente 54 in Serie / Brückenquadrant, dann wird durch die Trimmwiderstände 50 eine Genauigkeit von $\pm 50\,\%$, $\pm 25\,\%$ bzw. $\pm 12,5\,\%$ erreicht. Diese Genauigkeiten sind allesamt unbefriedigend. Eine bessere Trimmtechnologie ist erforderlich.

Die Technologie, die sowohl trimmbare Widerstände als auch gute Filterung ermöglicht, setzt sich zusammen aus vorteilhafterweise zwei (RX, RXT), drei (RX1, RX2, RXT) bzw. fünf (RX1, RX2, RX3, RX4, RXT) oder mehr Teilwiderständen pro Brückenwiderstandsanordnung R1, R2, R3 und R4.

Fig. 3 zeigt eine Messbrücke 10 in der in jeder Brückenwiderstandsanordnung ein einzelner magnetoresistiver (Teil-)Widerstand R1, R2, R3, R4 mit durch Pfeil indizierter Vorzugsrichtung vorgesehen ist. Die Vorzugsrichtungen der in Reihe geschalteten Widerstandsanordnungen jedes Brückenzweigs zeigen in antiparallele Richtungen, wobei beide Halbbrücken voneinander abgewinkelte Vorzugsrichtungen aufweisen.

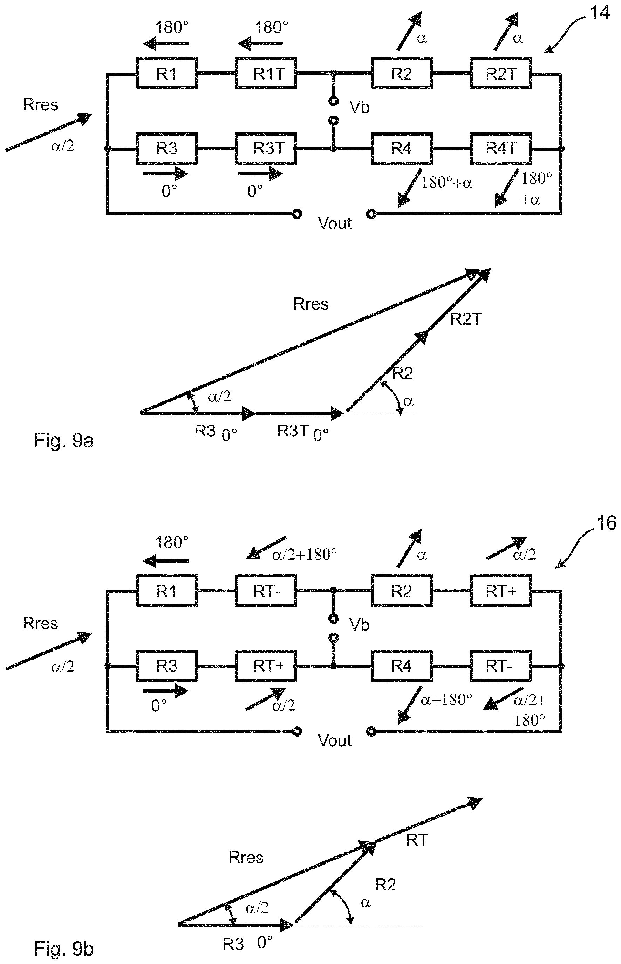

Die Figs. 9a und 9b zeigen analog hierzu zwei alternative, getrimmte Ausführungsbeispiele 14, 16, wobei in jedem Brückenzweig zusätzlich pro Brückenwiderstandsanordnung RX (X steht für die Position der Brückenwiderstandsanordnung 1, 2, 3 oder 4) ein Trimmwiderstand RXT vorgesehen ist, der die Vorzugsrichtung entweder pro Zweig oder für die Gesamtanordnung unverändert lässt, und den Einzelwiderstand der Brückenwiderstandsanordnung sowie den Gesamtwiderstand der Halbbrücke und der Gesamtbrücke einstellbar ist:

Wie in jeweils nebengeordneten Vektordiagrammen dargestellt ist, kann jeder Trimmwiderstand RXT entweder in dieselbe Vorzugsrichtung gepinnt sein, wie in Fig. 9a in der Brücke 14 gezeigt, wie die Vorzugsrichtung des Grundbrückenwiderstands R1, R2, R3, R4, so dass die Vorzugsrichtung des Brückenwiderstands an sich nicht verändert wird. Hierzu sind Trimmwiderstände R1T (0°), R2T ($\alpha$), R3T (0°) und R4T (180°-$\alpha$) vorzusehen, die in gleicher Richtung wie die übrige Vorzugsrichtung des Brückenwiderstands ausgerichtet sind.

Alternativ kann, wie in der Brücke 16 in Fig. 9b dargestellt, jeder Trimmwiderstand auch in Richtung der gewünschten Vorzugsrichtung der Gesamtbrücke ausgerichtet sein, so dass gleichartig ausgerichtete Trimmwiderstände RT+($\alpha$/2) bzw. Trimmwiderstände RT-(180°-$\alpha$/2) mit um 180° verdrehte Vorzugsrichtungen eingesetzt werden können.

Fertigungstechnisch und für eine vereinfachte Einstellung ist die obere Schaltungsvariante zu bevorzugen, d.h. die Trimmwiderstände weisen bevorzugt eine Vorzugsrichtung aus, die der Gesamtvorzugsrichtung des einzelnen Brückenwiderstands entspricht (linke Darstellung des nachfolgenden Vektordiagramms):

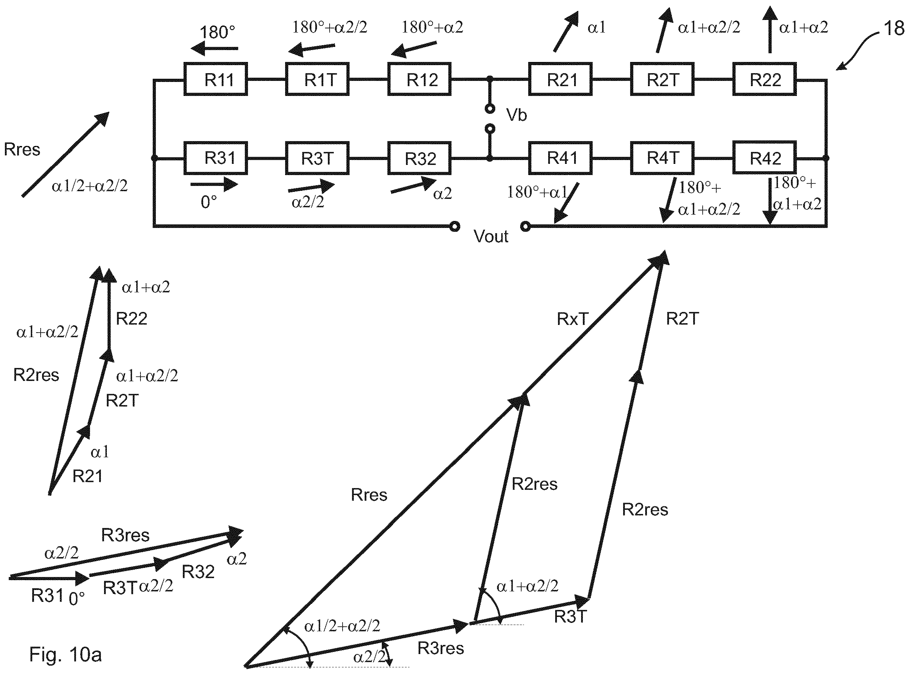

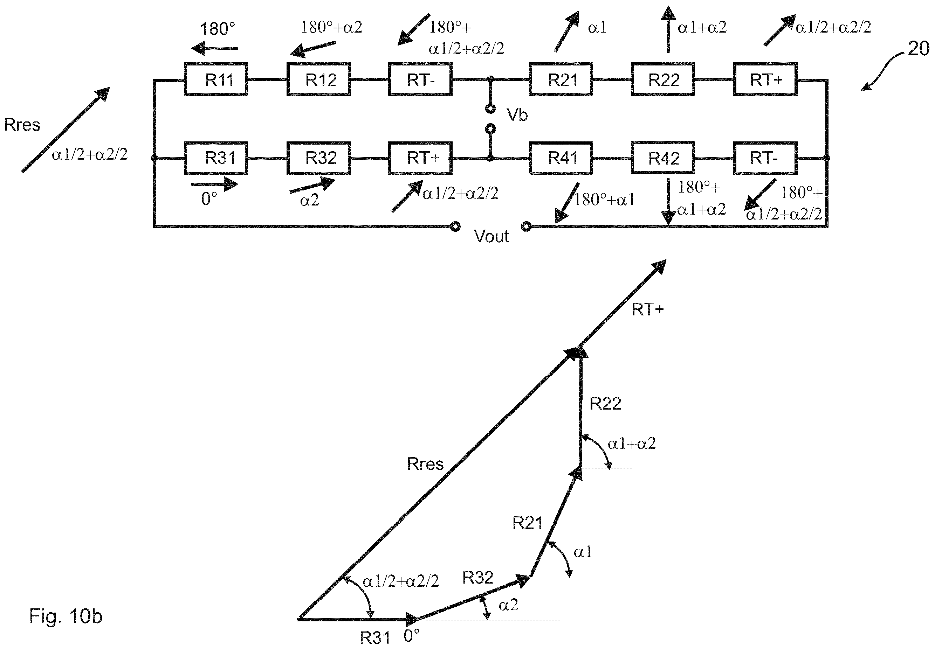

Sollen, wie in Fig. 4 dargestellt, mehrere Oberwellen gefiltert werden, so ergeben sich Ausführungsbeispiele von Schaltungsvarianten, die in den Figs. 10a und 10b dargestellt sind.

Dabei sind die Widerstände RX1 und RX2 jedes Brückenwiderstands X=1, 2, 3, 4 angeordnet wie in Fig. 4. Durch den Winkel α2 wird die 180°/ α2-te Oberwelle gefiltert. Diese beiden Widerstände haben beispielsweise jeweils 8, 16 bzw. 32 Tunnelelemente in Serie.

In der in der Fig. 10a dargestellte Konfiguration einer Brücke 18 ist der zwischen RX1 und RX2 eingeschaltete Trimmwiderstand RXT genau in der Winkelhalbierenden zwischen RX1 und RX2 ausgerichtet. Dies ist herstellungstechnisch besonders günstig, da nachfolgende Widerstände der Serienschaltung eine Änderung der Vorzugsrichtung bedürfen, die nicht sehr von der Vorzugsrichtung der vorhergehenden bzw. nachfolgenden Vorzugsrichtung abweicht, wodurch eine Pinningeinstellung erleichtert wird.

Alternativ können alle Trimmwiderstände RT+/- auch, wie in der Konfiguration der Brücke 20 nach Fig. 10b dargestellt, in die Gesamtvorzugsrichtung Rres (α1/2+α2/2) bzw. 180° verdreht dazu angeordnet sein. In den Figs. 10a und 10b zeigen entsprechende Vektordarstellungen der jeweils oberen Schaltungskonfiguration von Ausführungsbeispielen die Ausbildung der Vorzugsrichtung Rres.

Wie bereits weiter oben angemerkt, ist in Fig. 10a im Vektordiagramm der Brücke 18, bei der jeder Trimmwiderstand RXT eine Vorzugsrichtung in der Gesamtvorzugsrichtung RresX des Brückenwiderstands RX, zusammengesetzt aus RX1 & RX2 aufweist, zu bevorzugen, da es bei großen Widerstandstoleranzen sowohl fertigungstechnisch als auch theoretisch erleichtert möglich ist, die einzelnen Widerstände einzustellen. Die Vorzugsrichtung RresX gilt für die gesamte Halbbrücke, da beide Brückenwiderstände antiparallel ausgerichtet sind, und die Vorzugsrichtungssensitivität verstärken. Die Schaltungskonfiguration nach Fig. 10b, bei der jeder Trimmwiderstand RXT eine Vorzugsrichtung in der Vorzugsrichtung der Gesamtbrücke 20 aufweist, ist zu bevorzugen, wenn die Gesamtgröße des Brückenwiderstands verändert werden soll, bzw. falls nur geringfügige Widerstandstoleranzen auszugleichen sind.

Ein Trimmwiderstand besteht vorzugsweise aus z.B. vier Tunnelelementen. Durch die jeweilige Top-Elektrodenmaske ist es möglich, mit einer Auflösung von nur 2 Tunnelelementen zu trimmen. Hierdurch ist es möglich, dass bei 16, bzw. 32 bzw. 64 Elemente in Serie pro Brückenquadrant (Brückenwiderstand) der Widerstandswert mit einer Genauigkeit von 12,5 %, 6,25 % bzw. 3,125 % der Brückenwiderstandsanordnung einstellbar ist, ohne dass die Oberwellenfilterung beeinträchtigt wird. Die gleiche Trimmauflösung ist auch möglich, wenn vier Teilwiderstände R11, R12, R14, und R15 vorgesehen sind, die um den Winkel α1 und um den Winkel α2 aufgespaltet sind. Wieder liegt der Trimmwiderstand R13 in der Winkelhalbierenden von α1 und α2.

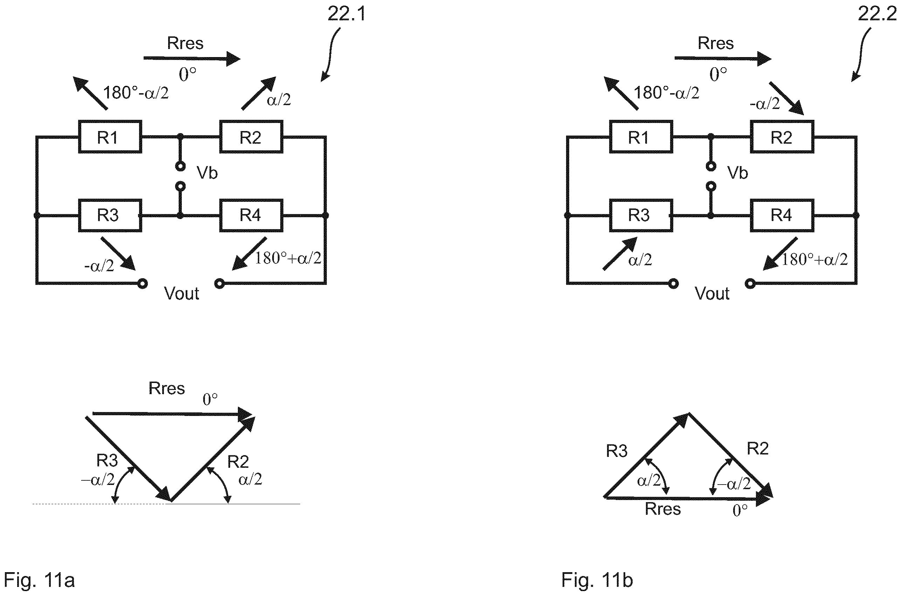

In der Fig. 11a und Fig. 11b sind weitere Ausführungsformen 22.1 bzw. 22.2 von Messbrücken dargestellt. In der Messbrücke 22.1 und 22.2 sind die Vorzugsrichtungen aller Widerstandsanordnungen um den Winkel -α/2 gegenüber denen der Widerstandsanordnungen der Messbrücken 10.1 und 10.2 der Fig. 3 gedreht, ansonsten entspricht die Messbrücke 22.1 der Messbrücke 10.1 und die Messbrücke 22.2 der Messbrücke 10.2. Somit sind die Vorzugsrichtungen aller Widerstandsanordnungen um denselben Winkelbetrag gedreht, um eine gewünschte Ausrichtung des Winkels der Gesamtvorzugsrichtung Rres der Messbrücke zu erreichen. Hierdurch kann eine Vorzugsrichtung unabhängig von einer gegebenen räumlichen Positionierung der Widerstandsanordnungen auf einem Chipsubstrat ausgerichtet werden. Nimmt man eine Hauptachse mit 0° an, die einer Ausrichtung der Vorzugsrichtung der Messbrücke 100 des Stands der Technik nach Fig. 1 entspricht, so ist in der Fig. 11a. die Vorzugsrichtung der Widerstandsanordnungen R1 und R3 der Messbrücke 22.1 um den Winkel -α/2 von der 0° bzw. der 180°-Achse abgewinkelt. Weiterhin weichen die beiden Winkel der Vorzugsrichtungen jeweils diagonal gegenüberliegender Widerstandsanordnung R1 und R4 bzw. R2 und R3 von der 0°-Hauptachse um einen positiven Winkel α/2 für R2 gegenüber 0° und negativen Winkel -α/2 für R3 gegenüber 0° und um einen negativen Winkel α/2 für R1 und positiven Winkel α/2 für R4 gegenüber 180° ab, so dass diagonale Widerstandsanordnungen um den Winkel α gegeneinander gedreht sind. Hierdurch ergibt sich weiterhin die Möglichkeit, Oberwellen zu unterdrücken. Vorzugsweise kann α=60° gewählt werden. Im untenstehenden Vektordiagramm ist ersichtlich, dass die Gesamtvorzugsrichtung Rres der Messbrücke 22.1 in Richtung der 0°-Hauptachse zeigt, so dass bereits im Chiplayout die Vorzugsachse klar erkennbar ist.

In der Fig. 11b ist eine Messbrücke 22.2 dargestellt, die sich aus der Messbrücke 22.1 durch Vertauschen von Messabgriff Vout und Versorgungskontakten Vb ergibt. Hierbei weichen die beiden Winkel der Vorzugsrichtungen jeweils diagonal gegenüberliegender Widerstandsanordnungen R1 und R4 bzw. R2 und R3 von der 0°-Achse 180° bzw. 0° um den positiven Winkel α/2 für R3 und negativen Winkel -α/2 für R2 gegenüber 0° und einen negativen Winkel -α/2 für R1 und einen positiven Winkel α/2 für R4 gegenüber 180° ab. Auch in diesem Fall ist die Achse der Vorzugsrichtung / Empfindlichkeitsrichtung für gleich große Widerstandsbeträge der Widerstandsanordnungen in die 0°-Hauptachse ausgerichtet.

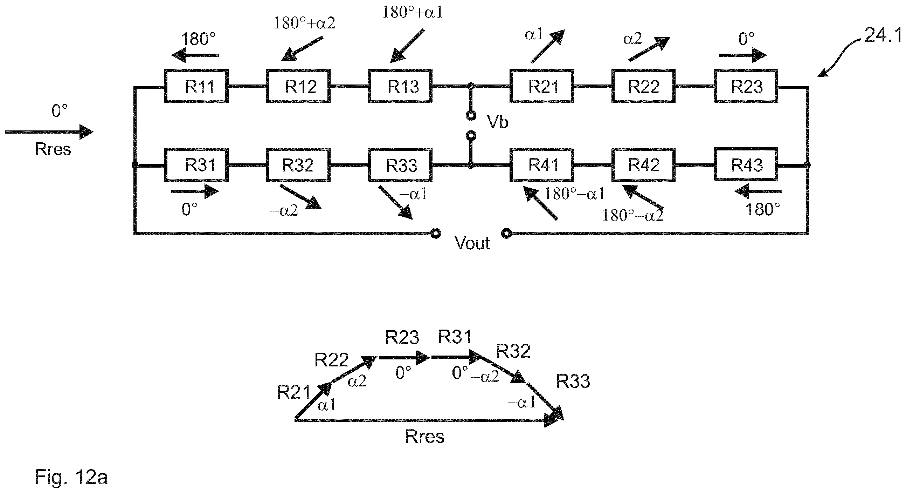

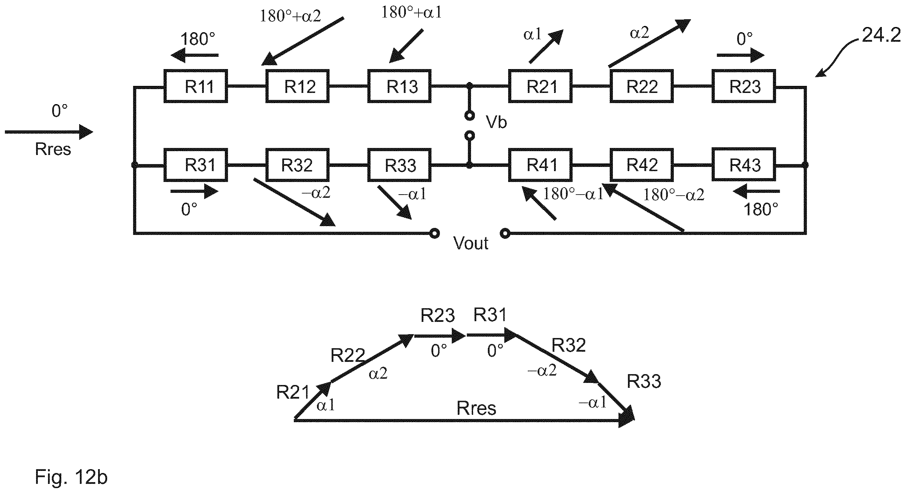

Die Figs. 12a und 12b stellen weitere Ausführungsbeispiele einer Messbrücke 24.1 bzw. 24.2 dar. Jede Widerstandsanordnung umfasst drei Teilwiderstände RX1, RX2 und RX3, wobei vorzugsweise der mittlere Teilwiderstand RX2 als Trimmwiderstand ausgeführt sein kann, allerdings auch die übrigen Widerstände Trimmwiderstände sein können. Jede Widerstandsanordnung R1, R2, R3 und R4 umfasst somit drei in Reihe geschaltete Widerstände, wobei die Vorzugsrichtung der Teilwiderstände RX2 und RX3 von der Vorzugsrichtung RX1 um die Winkel α2 und α1 abweichen. Die Vorzugsrichtungen der Teilwiderstände diagonal gegenüberliegende Widerstandsanordnungen unterscheiden sich dadurch, dass die Vorzeichen der Winkelabweichungen $\alpha2$ und $\alpha1$ umgedreht sind. So weichen die Winkel $\alpha1$, $\alpha2$ für R2X und R1X in die positive Richtung, für R3X und R4X in die negative Richtung ab.

Betrachtet man die resultierende Vorzugsrichtung der Widerstandsanordnungen R1, R2, R3 und R4 der Messbrücke 24.1 so ergibt sich eine Vorzugsrichtungskonfiguration vergleichbar mit der Messbrücke 22.2 der Fig. 11b, allerdings wird nicht nur eine Oberwelle sondern es können zwei Oberwellen ausgefiltert werden. Paarweise gegenüberliegende Widerstandsanordnungen weisen antiparallele Vorzugsrichtungen auf, diagonal gegenüberliegende Widerstandsanordnungen weisen Vorzugsrichtungen auf, die um einen festen Winkel voneinander abweichen. Ist $\alpha2=\alpha1/2$ gewählt, so entspricht $\alpha2$ der Messbrücke 24.1 dem Winkel $\alpha/2$ der Messbrücke 22.2. Vorteilhafterweise wird $\alpha2=30°$ und $\alpha1=60°$ gewählt.

Die Ausführungsform 24.2 der Fig. 12b entspricht der Ausführungsform der Fig. 12a, allerdings ist der Widerstandswert des mittleren Teilwiderstands RX2 betragsmäßig doppelt so groß wie der der Teilwiderstände RX1, RX3 gewählt. Liegt die Vorzugsrichtung RX2 in der Vorzugsrichtung der jeweiligen Widerstandsanordnung RX, d.h. gilt $\alpha2=\alpha1/2$, so stabilisiert eine Erhöhung des Widerstandswertes von RX2 die Ausrichtung der Vorzugsrichtung der Widerstandsanordnung. Im untenstehenden Vektordiagramm ist deutlich zu erkennen, dass die Vektorlängen der Teilwiderstände R22 und R32 doppelt so lang wie die Vektorlängen der übrigen Teilwiderstände sind, und somit die Vektorausrichtung Rres und das Gesamtwiderstandsverhalten dominieren. Eine Widerstandsveränderung an den Teilwiderständen R22, R32 ändert somit nichts an der Ausrichtung der Vorzugsrichtung, beeinflusst allerdings das Gesamtwiderstandsverhalten der Messbrücke

In der Erfindung können in jeder Widerstandsanordnung mehr als zwei oder drei Teilwiderstände mit verschiedenen Vorzugsrichtungen umfasst sein, so dass eine höhere Zahl von Oberwellen gefiltert werden können. Eine effektive Oberwellenfilterung wird durch das Zusammenspiel der Vorzugsrichtungen aller Widerstandsanordnungen zueinander erreicht. Oberwellen können bei Vorzugsrichtungen der Teilwiderständen bei 60° - 3. Oberwellennummer, 45° - 4. Oberwellennummer, 36° - 5. Oberwellennummer, 30° - 6. Oberwellennummer, d.h. bei [180/(Oberwellennummer)]° effektiv gefiltert werden.

### *Bezugszeichenliste*

| | |
|---|---|
| 10 | Erste Ausführungsform einer Wheatstone-Messbrücke |
| 12 | zweite Ausführungsform einer Wheatstone-Messbrücke |
| 14 | dritte Ausführungsform einer Wheatstone-Messbrücke |
| 16 | vierte Ausführungsform einer Wheatstone-Messbrücke |
| 18 | fünfte Ausführungsform einer Wheatstone-Messbrücke |
| 20 | sechste Ausführungsform einer Wheatstone-Messbrücke |
| 22 | siebte Ausführungsform einer Wheatstone-Messbrücke |
| 24 | achte Ausführungsform einer Wheatstone-Messbrücke |
| 30 | Winkelsensor |
| 32 | Chipsubstrat |
| 34 | Kontaktpatch |
| 36 | Leiterbahn |
| 38 | Magnetoresistiver Brückenwiderstand |
| 40 | Sinusbrücke |
| 42 | Kosinusbrücke |
| 50 | Trimmwiderstand |
| 52 | Top-Elektrode |
| 54 | Tunnelwiderstand / Tunnelelement |
| 56 | Bottom-Elektrode |
| 58 | Isolationsschicht |
| 60 | Elektrodenunterbrechung |
| 100 | Wheatstone-Messbrücke des Stands der Technik |
| 102 | Wheatstone-Messbrücke des Stands der Technik |

**Patentansprüche**

1. Magnetoresistive Wheatstone-Messbrücke (10, 12, 14, 16, 18, 20, 22, 24) umfassend zwei zwischen einem Versorgungspotential Vb parallel geschaltete Brückenzweige, wobei in jedem Brückenzweig zwei in Reihe geschattete Widerstandsanordnungen R1 und R3 bzw. R2 und R4 mit einem zwischenliegenden Messpotential Vout angeordnet sind, und die Widerstandsanordnungen R1 und R4 bzw. R2 und R3 der beiden Brückenzweige diagonal gegenüberliegen, und zumindest zwei magnetoresistive Widerstandsanordnungen R1, R2, R3, R4 eine magnetisch sensitive Vorzugsrichtung aufweisen, wobei die Vorzugsrichtungen diagonal gegenüberliegender magnetoresistiver Widerstandsanordnungen der Brückenzweige R1 und R4 bzw. R2 und R3 um einen Winkel ungleich 0° oder 180° voneinander abweichen, **dadurch gekennzeichnet, dass** die Vorzugsrichtungen der in Reihe geschalteten Widerstandsanordnungen R1 und R3 bzw. R2 und R4 jedes Brückenzweigs antiparallel ausgerichtet sind, oder die Vorzugsrichtungen der in den Brückenzweigen jeweils paarweise gegenüberliegenden Widerstandsanordnungen R1 und R2 bzw. R3 und R4 antiparallel ausgerichtet sind.

2. Wheatstone-Messbrücke (10, 12, 14, 16, 18, 20, 22, 24) nach Anspruch 1, **dadurch gekennzeichnet, dass** das betragsmäßige Widerstandsverhalten jeder Widerstandsanordnungen R1, R2, R3, R4 identisch ist.

3. Winkelsensor (30) nach einem der vorangegangenen Ansprüche, **dadurch gekennzeichnet, dass** die Widerstandsanordnungen AMR-, GMR-, oder TMR-Widerstandsanordnungen sind, die auf einem Chipsubstrat angeordnet sind,

4. Wheatstone-Messbrücke (10, 12, 14, 16, 18, 20, 22, 24) nach einem der vorangegangenen Ansprüche, **dadurch gekennzeichnet, dass** jede Widerstandsanordnung R1, R2, R3, R4 einen magnetoresistiven Widerstand mit einer Vorzugsrichtung umfasst, wobei die Vorzugsrichtungen diagonal gegenüberliegender Widerstandsanordnungen der Brückenzweige R1 und R4 bzw. R2 und R3 um einen Winkel $\alpha$ voneinander abweichen, insbesondere um einen Winkel $\alpha$=60°.

5. Wheatstone-Messbrücke (10, 12, 14, 16, 18, 20, 22, 24) nach einem der vorangegangenen Ansprüche 1 bis 3, **dadurch gekennzeichnet, dass** jede Widerstandsanordnung R1, R2, R3, R4 zumindest zwei magnetoresistive Widerstände RX1, RX2 mit gegeneinander um einen Winkel $\alpha$2 oder um weitere Winkel versetzten Vorzugsrichtungen umfasst, wobei die resultierenden Vorzugsrichtungen diagonal gegenüberliegender Widerstandsanordnungen der Brückenzweige R1 und R4 bzw. R2 und R3 um einen Winkel $\alpha$1 voneinander abweichen, wobei bevorzugt $\alpha$1=60° und $\alpha$2=30° oder $\alpha$2=36° beträgt.

6. Wheatstone-Messbrücke (10, 12, 14, 16, 18, 20, 22, 24) nach einem der vorangegangenen Ansprüche, **dadurch gekennzeichnet, dass** zumindest in einer Widerstandsanordnung R1, R2, R3 oder R4 ein Trimmwiderstand (50) RXT in Reihe geschaltet ist, der bevorzugt so gewählt ist, dass ein betragsmäßig gleiches Widerstandsverhalten der Widerstandsanordnungen R1, R2, R3 und R4 gegeben ist.

7. Wheatstone-Messbrücke (10, 12, 14, 16, 18, 20, 22, 24) nach einem der vorangegangenen Ansprüche, **dadurch gekennzeichnet, dass** der Trimmwiderstand (50) ein magnetoresistiver Widerstand ist, der eine Trimmwiderstands-Vorzugsrichtung aufweist, insbesondere ein TMR-Widerstand ist.

8. Wheatstone-Messbrücke (10, 12, 14, 16, 18, 20, 22, 24) nach Anspruch 7, **dadurch gekennzeichnet, dass** die Trimmwiderstands-Vorzugsrichtung in Richtung einer Vorzugsrichtung eines Widerstands der Widerstandsanordnung, in Richtung der resultierenden Vorzugsrichtung der Widerstandsanordnung oder in Richtung der Gesamtvorzugsrichtung der Wheatstone-Messbrücke (10, 12, 14, 16, 18, 20) ausgerichtet ist.

9. Wheatstone-Messbrücke (10, 12, 14, 16, 18, 20, 22, 24) nach einem der Ansprüche 6 bis 8, **dadurch gekennzeichnet, dass** der Trimmwiderstand (50) eine Aneinanderreihung von zumindest zwei Tunnelwiderständen (54) zwischen Top-Elektroden (52) und Bottom-Elektroden (56) umfasst, wobei der Trimmwiderstand (50) durch eine Elektrodenunterbrechung (60) oder Elektrodenkurzschluss der Top-Elektrode (52) oder der Bottom-Elektrode (56) einstellbar ist.

10. Wheatstone-Messbrücke (10, 12, 14, 16, 18, 20, 22, 24) nach einem der Ansprüche 6 bis 9, **dadurch gekennzeichnet, dass** der Trimmwiderstand (50) eine Reihen- und/oder eine Parallelschaltung mehrerer Teiltrimmwiderstände, insbesondere mehrerer Tunnelwiderstände (52) umfasst, wobei die Anzahl der Parallelzweige und/oder der Reihenwiderstände jedes Parallelzweigs einstellbar ist.

11. Winkelsensor (30), **dadurch gekennzeichnet, dass** der Winkelsensor (30) zumindest zwei um einen vordefinierten Winkel, insbesondere um 90° versetzte magnetoresistive Wheatstone-Messbrücken (10, 12, 14, 16, 18, 20, 22, 24) nach einem der vorgenannten Ansprüche zur Bestimmung einer Winkelausrichtung eines Magnetfeldes mittels einer ersten und einer zweiten Sensorbrücke (40, 42), insbesondere einer Sinusbrücke und einer Kosinusbrücke umfasst.

12. Winkelsensor (30) nach Anspruch 11, **dadurch gekennzeichnet, dass** Widerstandsanordnungen RX1, RX2 des ersten Brückenzweigs R1-R3 (40-1, 42-1) der ersten Sensorbrücke (40, 42) und der zweiten Sensorbrücke (42) auf einem Chipsubstrat (32) räumlich benachbart angeordnet sind, und Widerstandsanordnungen RX1, RX2 des zweiten Brückenzweigs R2-R4 (40-2, 42-2) der ersten Sensorbrücke (40) und der zweiten Sensorbrücke (42) auf dem Chipsubstrat (32) räumlich benachbart angeordnet, und die ersten und zweiten Brückenzweige R1-R3 und R2-R4 (40-1 und 40-2 sowie 42-1 und 42-2) diagonal zueinander auf dem Chipsubstrat (32) angeordnet sind.

**Claims**

1. Magnetoresistive Wheatstone bridge (10, 12, 14, 16, 18, 20, 22, 24) comprising two bridge branches connected in parallel between a supply potential Vb, two series-connected resistor arrangements R1 and R3 or R2 and R4 being arranged in each bridge branch with an interposed measuring potential Vout, and the resistor arrangements R1 and R4 or R2 and R3 of the two bridge branches being diagonally opposite and at least two magnetoresistive resistor arrangements R1, R2, R3, R4 having a magnetically sensitive preferred direction, the preferred directions of diagonally opposing magnetoresistive resistor arrangements of the bridge branches R1 and R4 or R2 and R3 differing from one another by an angle other than 0° or 180, **characterised in that** the preferred directions of the series-connected resistor arrangements R1 and R3 or R2 and R4 of each bridge branch are oriented antiparallel, or the preferred directions of the resistor arrangements R1 and R2 or R3 and R4 situated opposite one another in pairs in the bridge branches are oriented antiparallel.

2. Wheatstone bridge (10, 12, 14, 16, 18, 20, 22, 24) according to claim 1, **characterised in that** the resistance behaviour of each resistor arrangement R1, R2, R3, R4 is identical in respect of magnitude.

3. Wheatstone bridge (10, 12, 14, 16, 18, 20, 22, 24) according to one of the preceding claims, **characterised in that** the resistor arrangements are AMR, GMR, or TMR resistor arrangements, which are arranged on a chip substrate.

4. A Wheatstone bridge (10, 12, 14, 16, 18, 20, 22, 24) according to one of the preceding claims, **characterised in that** each resistor arrangement R1, R2, R3, R4 comprises a magnetoresistive resistor with a preferred direction, wherein the preferred directions of diagonal opposing resistor arrangements of the bridge branches R1 and R4 or R2 and R3 differ by an angle $\alpha$ from one another, in particular by an angle $\alpha=60°$.

5. Wheatstone bridge (10, 12, 14, 16, 18, 20, 22, 24) according to one of preceding claims 1 to 3, **characterised in that** each resistor arrangement R1, R2, R3, R4 comprises at least two magnetoresistive resistors RX1, RX2 with preferred directions offset relative to one another by an angle $\alpha2$ or by further angles, wherein the resultant preferred directions of diagonally opposing resistor arrangements of the bridge branches R1 and R4 or R2 and R3 differ from one another by an angle $\alpha1$, wherein preferably $\alpha1=60°$ and $\alpha2=30°$ or $\alpha2=36°$.

6. Wheatstone bridge (10, 12, 14, 16, 18, 20, 22, 24) according to one of the preceding claims, **characterised in that,** at least in a resistor arrangement R1, R2, R3 or R4, a trimming resistor (50) RXT is series-connected which is preferably selected so as to result in a resistance behaviour identical with regard to magnitude of the resistor arrangements R1, R2, R3 and R4.

7. Wheatstone bridge (10, 12, 14, 16, 18, 20, 22, 24) according to one of the preceding claims, **characterised in that** the trimming resistor (50) is a magnetoresistive resistor which has a trimming resistor preferred direction, in particular is a TMR resistor.

8. Wheatstone bridge (10, 12, 14, 16, 18, 20, 22, 24) according to claim 7, **characterised in that** the trimming resistor preferred direction may be oriented in the direction of a preferred direction of one resistor of the resistor arrangement, in the direction of the resultant preferred direction of the resistor arrangement or in the direction of the overall preferred direction of the Wheatstone bridge (10, 12, 14, 16, 18, 20, 22, 24).

9. Wheatstone bridge (10, 12, 14, 16, 18, 20, 22, 24) according to one of preceding claims 6 to 8, **characterised in that** the trimming resistor (50) may comprise a concatenation of at least two tunnel resistors (54) between top electrodes (52) and bottom electrodes (56), wherein the trimming resistor (50) is adjustable by electrode interruption (60) or electrode short-circuit of the top electrode (52) or of the bottom electrode (56).

10. Wheatstone bridge (10, 12, 14, 16, 18, 20, 22, 24) according to one of preceding claims 6 to 9, **characterised in that** the trimming resistor (50) comprises a series and/or parallel connection of a plurality of trimming subresistors, in particular a plurality of tunnel resistors (52), wherein the number of parallel branches and/or series resistors of each parallel branch is adjustable.

11. Angle sensor (30), **characterised in that** the angle sensor (30) comprises at least two magnetoresistive Wheatstone bridges (10, 12, 14, 16, 18, 20, 22, 24) offset by a predefined angle, in particular by 90°, according to one of the above-stated claims, for determining an angular orientation of a magnetic field by means of a first and a second sensor bridge (40, 42), in particular a sine bridge and a cosine bridge,

12. Angle sensor (30) according to claim 11, **characterised in that** resistor arrangements RX1, RX2 of the first bridge branch R1-R3 (40-1, 42-1) of the first sensor bridge (40, 42) and the second sensor bridge (42) are arranged spatially adjacently on a chip substrate (32), and resistor arrangements RX1, RX2 of the second bridge branch R2-R4 (40-2, 42-2) of the first sensor bridge (40) and of the second sensor bridge (42) are arranged spatially adjacently on the chip substrate (32), and the first and second bridge branches R1-R3 and R2-R4 (40-1, 40-2 and 42-1, 42-2) are arranged diagonally relative to one another on the chip substrate (32).

## Revendications

1. Pont de mesure magnétorésistif de Wheatstone (10, 12, 14, 16, 18, 20, 22, 24) comprenant deux branches de pont branchées en parallèle entre un potentiel d'alimentation Vb, sachant que deux systèmes de résistance R1 et R3, ainsi que R2 et R4 montés en série sont agencés dans chaque branche de pont, avec entre elles un potentiel de mesure Vout et que les systèmes de résistance R1 et R4 ainsi que R2 et R3 des deux branches de pont sont diagonalement opposés et qu'au moins deux systèmes de résistance magnétorésistifs R1, R2, R3, R4 présentent une orientation préférée magnétosensible, sachant que les orientations préférées des systèmes de résistance diagonalement opposés R1 et R4 ainsi que R2 et R3 des branches de pont divergent l'une de l'autre d'un angle différent de 0° ou de 180°, **caractérisé en ce que** les orientations préférées des systèmes de résistance branchés en série R1 et R3 ainsi que R2 et R4 de chaque branche de pont sont orientées antiparallèlement ou que les orientations préférées des systèmes de résistance R1 et R2 ainsi que R3 et R4 opposés par paire dans les branches de pont sont orientées antiparallèlement.

2. Pont de mesure de Wheatstone (10, 12, 14, 16, 18, 20, 22, 24) selon la revendication 1, **caractérisé en ce que** le comportement de résistance de chaque système de résistance R1, R2, R3, R4 est identique en valeur.

3. Capteur d'angle (30) selon une des revendications précédentes, **caractérisé en ce que** les systèmes de résistance sont des systèmes de résistance AMR, GMR ou TMR disposés sur un substrat de puce.

4. Pont de mesure de Wheatstone (10, 12, 14, 16, 18, 20, 22, 24) selon une des revendications précédentes, **caractérisé en ce que** chaque système de résistance R1, R2, R3, R4 comprend une résistance magnétorésistive avec une orientation préférée, sachant que les orientations préférées des systèmes de résistance diagonalement opposés R1 et R4 ainsi que R2 et R3 des branches de pont divergent d'un angle $\alpha$, notamment d'un angle $\alpha$=60°.

5. Pont de mesure de Wheatstone (10, 12, 14, 16, 18, 20, 22, 24) selon une des revendications précédentes 1 à 3, **caractérisé en ce que** chaque système de résistance R1, R2, R3, R4 comprend au moins deux résistances magnétorésistives RX1, RX2 avec des orientations préférées décalées d'un angle $\alpha$2 ou d'autres angles, sachant que les orientations préférées résultantes des systèmes de résistance diagonalement opposés R1 et R4 ainsi que R2 et R3 des branches de pont divergent les unes des autres d'un angle $\alpha$1, sachant que de préférence $\alpha$1=60° et $\alpha$2=30° ou $\alpha$2=36°.

6. Pont de mesure de Wheatstone (10, 12, 14, 16, 18, 20, 22, 24) selon une des revendications précédentes, **caractérisé en ce qu'**est branchée en série dans un système de résistance R1, R2, R3 ou R4 au moins une résistance de réglage (50) RXT qui est sélectionnée de préférence de telle sorte qu'un comportement identique en valeur des systèmes de résistance R1, R2, R3 et R4 est obtenu.

7. Pont de mesure de Wheatstone (10, 12, 14, 16, 18, 20, 22, 24) selon une des revendications précédentes, **caractérisé en ce que** la résistance de réglage (50) est une résistance magnétorésistive qui présente une orientation préférée de la résistance de réglage et qui est notamment une résistance TMR.

8. Pont de mesure de Wheatstone (10, 12, 14, 16, 18, 20, 22, 24) selon la revendication 7, **caractérisé en ce que** l'orientation préférée de la résistance de réglage est orientée dans le sens d'une orientation préférée d'une résistance du système de résistance, ou dans le sens de l'orientation préférée résultante du système de résistance ou dans le sens de l'orientation préférée totale du pont de mesure de Wheatstone (10, 12, 14, 16, 18, 20, 22, 24).

9. Pont de mesure de Wheatstone (10, 12, 14, 16, 18, 20, 22, 24) selon une des revendications 6 à 8, **caractérisé en ce que** la résistance de réglage (50) comprend une rangée d'au moins deux résistances à effet tunnel (54) entre les électrodes supérieures (52) et les électrodes inférieures (56), sachant que ladite résistance de réglage (50) est réglable par le biais d'une interruption de l'électrode (60) ou d'un court-circuitage de l'électrode supérieure (52) ou de l'électrode inférieure (56).

10. Pont de mesure de Wheatstone (10, 12, 14, 16, 18, 20, 22, 24) selon une des revendications 6 à 9, **caractérisé en ce que** la résistance de réglage (50) comprend un branchement en série et/ou en parallèle de plusieurs résistances partielles de réglage, notamment de plusieurs résistances à effet tunnel (52), sachant que le nombre des branches parallèles et/ou des résistances en série de chaque branche parallèle est modifiable.

11. Capteur d'angle (30), **caractérisé en ce que** le capteur d'angle (30) comprend au moins deux ponts de mesure magnétorésistifs de Wheatstone (10, 12, 14, 16, 18, 20, 22, 24) selon une des revendications précédentes, décalés d'un angle prédéfini, notamment de 90°, pour déterminer une orientation d'angle d'un champ magnétique au moyen d'un premier et d'un second capteur en pont (40, 42), notamment d'un pont sinus et d'un pont cosinus.

12. Capteur d'angle (30) selon la revendication 11, **caractérisé en ce que** les systèmes de résistance RX1, RX2 de la première branche de pont R1-R3 (40-1, 42-1) du premier capteur en pont (40, 42) et du second capteur en pont (42) sont adjacents sur un substrat de puce (32), que des systèmes de résistance RX1, RX2 de la seconde branche de pont R2-R4 (40-2, 42-2) du premier capteur en pont (40) et du second capteur en pont (42) sont adjacents sur le substrat de puce (32) et que les premières et secondes branches de pont R1-R3 et R2-R4 (40-1 et 40-2 ainsi que 42-1 et 42-2) sont disposées en diagonale l'une par rapport à l'autre sur le substrat de puce (32).

Fig.1

Stand der Technik

Stand der Technik

Fig.2

Fig.3a

Fig.3b

EP 3 224 639 B1

Fig.4a

Fig.4b

Fig. 5

Fig.6a

EP 3 224 639 B1

Fig.6b

EP 3 224 639 B1

Fig.7a

Fig.7b

Fig.7c

RT=2r
Fig 8a

RT=4r
Fig 8b

RT=4/3r
Fig 8c

RT=r
Fig 8d

Fig. 9a

Fig. 9b

Fig. 10a

EP 3 224 639 B1

Fig. 10b

Fig. 11a

Fig. 11b

Fig. 12a

Fig. 12b

EP 3 224 639 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6633462 B2
- EP 2455720 A1
- DE 19839450
- US 2013099783 A
- DE 4438715
- US 2002006017 A
- US 2008272771 A